# EUROPEAN PATENT APPLICATION

(11) **EP 4 610 606 A1**
(43) Date of publication of application: **03.09.2025**
(21) Application number: 23882407.2
(22) Date of filing: 10.10.2023
(51) Int. Cl.: G01J 1/42, G01J 1/02, H10N 10/00

(54) **INFRARED SENSOR**

(30) Priority: 25.10.2022 JP 2022170765
(71) Applicant: Panasonic Intellectual Property Management Co., Ltd., Kadoma-shi, Osaka 571-0057 (JP)
(72) Inventor: NAKAMURA Kunihiko, Kadoma-shi, Osaka 571-0057 (JP)
(74) Representative: Grünecker Patent- und Rechtsanwälte PartG mbB
(86) International application number: PCT/JP2023/036729
(87) International publication number: WO 2024/090198

(57) **Abstract**

An infrared sensor (201) includes a substrate, an infrared sensor element (10) that generates an infrared detection signal, a parallel switch (SW2) connected to the infrared sensor element (10), and an amplifier (112) that amplifies the infrared detection signal generated by the infrared sensor element (10). The infrared sensor element (10) includes a light receiver, a floating supporter that supports the light receiver in a floating manner so that a gap is formed between the substrate and the light receiver, and a thermoelectric converter that generates the infrared detection signal based on heat generated by the light receiver. The thermoelectric converter includes a first terminal (T1) that outputs the infrared detection signal, and a second terminal (T2) that is maintained at a predetermined potential. The parallel switch (SW2) connects the first terminal (T1) and the second terminal (T2) so that the parallel switch (SW2) is capable of short-circuiting the first terminal (T1) and the second terminal (T2). The amplifier (112) is a current-input amplifier.

## Description

### Technical Field

The present disclosure relates to an infrared sensor.

### Background Art

An infrared sensor using an infrared sensor element that detects infrared light based on heat that is generated when a light receiver receives the infrared light is known. As such an infrared sensor, an infrared imaging device (infrared image sensor) in which infrared sensor elements are arrayed as pixels is known. In order to arrange a large number of pixels with high density to acquire a high-resolution infrared image by using a small imaging device, there is means of reducing the area of an infrared sensor element per pixel. This can be realized by miniaturization of semiconductor manufacturing processes. A signal generated from an infrared sensor element for one pixel is processed by an analog front end. Hereafter, an analog front end will be referred to as "AFE". An AFE is mainly composed of, for example, an amplifier, a filter, and an AD (Analog-to-Digital) converter. When an infrared sensor includes one AFE for multiple infrared sensor elements, a pixel selection switch that selects some of the infrared sensor elements and connects the selected infrared sensor elements to the AFE is provided between the infrared sensor elements and the AFE. Scanning of pixels can be realized by switching selected pixels at certain time intervals by using the pixel selection switch. That is, infrared detection signals are output to the AFE from the successively selected pixels. The pixel selection switch and the AFE can be also realized by a miniaturized semiconductor manufacturing process. It is possible to integrate the infrared sensor element, the pixel selection switch, and the AFE on the same semiconductor substrate, or to make some of these as independent chips and integrate these by mounting technology.

On the other hand, if the area of a light receiver of an infrared sensor element is reduced, the power of received infrared light becomes very weak. Moreover, if a light receiver having a small area is used, it is difficult to obtain a spatial temperature difference. With an infrared sensor element using a thermocouple, a thermopile, or the like that uses the Seebeck effect, that is, an electromotive voltage based on a temperature difference as an infrared detection signal, the electromotive voltage becomes weaker and S/N (Signal/Noise; signal-to-noise ratio) decreases as the temperature difference decreases. To address the problem, PTL 1 discloses a technology for supporting a light receiver in a floating manner in an infrared sensor by using a floating supporter having a phononic crystal structure having high heat insulating properties. With this technology, it is possible to suppress decrease of S/N while maintaining a spatial temperature difference. To be specific, in a thermopile-type infrared sensor structure including a substrate, a light receiver that is separated from the substrate, and a floating supporter that supports the light receiver while separating the light receiver above the substrate, a phononic crystal structure is provided in the floating supporter, a cold junction is provided on the substrate side, and a hot junction is provided on the light receiver side. As a result, the hot junction temperature on the light receiver whose temperature has been changed by radiation of infrared light can easily maintain a temperature difference from the cold junction temperature due to high heat insulating properties of the phononic crystal structure, and an electromotive voltage due to the Seebeck effect can be effectively obtained.

### Citation List

### Patent Literature

PTL 1: International Publication No. 2019/225058

### Summary of Invention

The present disclosure provides an infrared sensor that can increase the infrared detection accuracy.

An infrared sensor according to an aspect of the present disclosure includes a substrate, a sensor element that generates an infrared detection signal, a first switch that is connected to the sensor element, and an amplifier that amplifies the infrared detection signal generated by the sensor element. The sensor element includes a light receiver that is positioned above the substrate, a floating supporter that joins the substrate and the light receiver and supports the light receiver in a floating manner so that a gap is formed between the substrate and the light receiver, and a thermoelectric converter that generates the infrared detection signal based on heat generated by the light receiver. The thermoelectric converter includes a first terminal that outputs the infrared detection signal and a second terminal that is maintained at a predetermined potential. The first switch connects the first terminal and the second terminal so that the first switch is capable of short-circuiting the first terminal and the second terminal. The amplifier is a current-input amplifier.

An infrared sensor according to an aspect of the present disclosure includes a substrate, sensor elements each of which generates an infrared detection signal, first switches that are connected one-to-one to the sensor elements, an amplifier that amplifies the infrared detection signals generated by the sensor elements, second switches that are connected one-to-one to the sensor elements and each of which individually switches between electrical connection and electrical disconnection between a corresponding one of the sensor elements and the amplifier, and a third switch that is connected to an input terminal of the amplifier and that is capable of short-circuiting the input terminal to a reference potential. Each of the sensor elements includes a light receiver that is positioned above the substrate, a floating supporter that joins the substrate and the light receiver and supports the light receiver in a floating manner so that a gap is formed between the substrate and the light receiver, and a thermoelectric converter that generates the infrared detection signal based on heat generated by the light receiver. The thermoelectric converter includes a first terminal that outputs the infrared detection signal and a second terminal that is maintained at a predetermined potential. Each of the first switches connects the first terminal and the second terminal so that the first switch is capable of short-circuiting the first terminal and the second terminal. Each of the second switches is a semiconductor switch. The amplifier is a voltage-input amplifier.

With the present disclosure, it is possible to increase the infrared detection accuracy.

### Brief Description of Drawings

[Fig. 1A] Fig. 1A illustrates the circuit configuration of an infrared sensor according to a configuration example 1.
[Fig. 1B] Fig. 1B illustrates the circuit configuration of an infrared sensor according to a configuration example 2.
[Fig. 1C] Fig. 1C illustrates the circuit configuration of an infrared sensor according to a configuration example 3.
[Fig. 1D] Fig. 1D illustrates the circuit configuration of an infrared sensor according to a configuration example 4.
[Fig. 1E] Fig. 1E illustrates the circuit configuration of an infrared sensor according to a configuration example 5.
[Fig. 1F] Fig. 1F is a table showing the result of calculating the leakage of an infrared detection signal in the configuration examples illustrated in Figs. 1A to 1E.
[Fig. 2] Fig. 2 is a block diagram illustrating the overall configuration of an infrared sensor according to a first embodiment.
[Fig. 3A] Fig. 3A is a sectional view illustrating the infrared sensor element according to the first embodiment.
[Fig. 3B] Fig. 3B is a plan view of the infrared sensor according to the first embodiment as seen from above.
[Fig. 4A] Fig. 4A is a sectional view illustrating a method of manufacturing the infrared sensor according to the first embodiment.
[Fig. 4B] Fig. 4B is a sectional view illustrating the method of manufacturing the infrared sensor according to the first embodiment.
[Fig. 4C] Fig. 4C is a sectional view illustrating the method of manufacturing the infrared sensor according to the first embodiment.
[Fig. 5] Fig. 5 illustrates the circuit configuration of the infrared sensor according to the first embodiment.
[Fig. 6] Fig. 6 illustrates the circuit configuration of an infrared sensor according to a comparative example 1.
[Fig. 7] Fig. 7 illustrates the circuit configuration of an infrared sensor according to a comparative example 2.
[Fig. 8] Fig. 8 is a table showing the result of calculating the leakage of the infrared detection signal in the infrared sensors according to the first embodiment, the comparative example 1, and the comparative example 2.
[Fig. 9] Fig. 9 is a block diagram illustrating the overall configuration of an infrared sensor according to a second embodiment.
[Fig. 10] Fig. 10 illustrates the circuit configuration of the infrared sensor according to the second embodiment.
[Fig. 11] Fig. 11 is a table showing the result of calculating the leakage of the infrared detection signal in the infrared sensor according to the second embodiment.
[Fig. 12A] Fig. 12A illustrates an example of a switch operation in an infrared detection mode of the infrared sensor according to the second embodiment.
[Fig. 12B] Fig. 12B illustrates another example of a switch operation in the infrared detection mode of the infrared sensor according to the second embodiment.
[Fig. 12C] Fig. 12C is a plan view illustrating an example of the arrangement of infrared sensor elements in an element array.
[Fig. 13] Fig. 13 is a bock diagram illustrating the overall configuration of an infrared sensor according to a third embodiment.
[Fig. 14] Fig. 14 illustrates the circuit configuration of the infrared sensor according to the third embodiment.
[Fig. 15] Fig. 15 is a table showing the result of calculating the leakage of the infrared detection signal in the infrared sensor according to the third embodiment. Description of Embodiments

### (Underlying Knowledge Forming Basis of the Present Disclosure)

For infrared sensors, improvement of infrared detection accuracy is required. The technology described in PTL 1 is a technology for improving infrared detection accuracy by improving (increasing) the S-component of S/N. On the other hand, it is also possible to improve infrared detection accuracy by improving (reducing) the N-component of S/N. For example, the N-component of S/N can be improved by using a method of cancelling the drift (that is, the offset component) of an offset voltage and the 1/f noise generated in an amplifier by signal processing. A specific example of such a method is a method of signal processing a signal that is obtained by opening and closing a mechanical shutter that is provided between an infrared sensor and an infrared light source.

With this method, as the first step, output information of an AFE when the shutter is "closed" is acquired. That is, output information that is output from the AFE in a state in which an infrared detection signal is not output from an infrared sensor element to the AFE is acquired. Hereafter, such a processing method with which information is output from the AFE in the state in which an infrared detection signal is not output from the infrared sensor element may be referred to as a "noise measurement mode". The output information of the AFE when the shutter is "closed" is information about the offset component and the 1/f noise of the amplifier and does not include information derived from infrared light.

Next, as the second step, output information of the AFE when the shutter is "open" is acquired. That is, output information that is output when an infrared detection signal is output from the infrared sensor element to the AFE and the infrared detection signal is processed by the AFE is acquired. Hereafter, such a processing method with which information is output when an infrared detection signal is output from the infrared sensor element to the AFE and the infrared detection signal is processed by the AFE may be referred to as an "infrared measurement mode". The output information of the AFE when the shutter is "open" is the sum of information derived from infrared light and the offset component and the 1/f noise of the amplifier.

Lastly, as the third step, the difference between the output information in the second step and the output information in the first step is calculated. The difference in output information is infrared information such that the offset component and the 1/f noise of the amplifier are cancelled (removed) from information based on the infrared detection signal. As a result, the N-component of S/N is reduced, and the detection accuracy of the infrared sensor can be improved. The output information of the AFE obtained in each of the first step and the second step may be converted by an AD converter into encoded digital information. Thus, the processing for calculating the difference in the third step is facilitated. The order of the noise measurement mode and the infrared measurement mode may be reversed. Whichever of the noise measurement mode and the infrared measurement mode is performed first, two measurement modes, which are the noise measurement mode and the infrared measurement mode, are performed in a short time in which change in the drift of the offset voltage and the 1/f noise of the amplifier can be neglected.

Because the mechanical shutter is not suitable for a small imaging device, by using a semiconductor switch instead of the mechanical shutter to artificially open and close a shutter, it is possible to realize the noise measurement mode and the infrared measurement mode by using the semiconductor switch. For example, it is possible to switch between the noise measurement mode and the infrared measurement mode by turning on and off a semiconductor switch. Hereafter, such a semiconductor switch may be referred to as a "measurement mode switch". For example, the aforementioned pixel selection switch functions also as the measurement mode switch. For example, even when the infrared sensor element is generating an infrared detection signal, the noise measurement mode is realized by turning off (closing) the measurement mode switch, which is provided between the infrared sensor element and the AFE, to electrically disconnect the infrared sensor element and the AFE, and the infrared measurement mode is realized by turning on (opening) the measurement mode switch to electrically connect the infrared sensor element and the AFE.

The inventor has found that the following problem arises when the measurement mode is switched by using such a semiconductor switch.

In general, a semiconductor switch using an ordinary semiconductor device excels in switching speed but has a problem in isolation (insulation), compared with a mechanical switch. The fact that isolation is bad means, in other words, even in a state in which the switch is off, there may be a case where a current leaks slightly and the resistance of the switch cannot be regarded as infinity. Therefore, as the signal intensity of an infrared detection signal generated by the infrared sensor element increases, the magnitude of a signal that leaks from the measurement mode switch when the switch is off increases. That is, when the signal intensity of the infrared detection signal generated by the infrared sensor element is high, in the noise measurement mode, an infrared detection signal that cannot be blocked by the measurement mode switch is output to the AFE, and it is not possible to accurately measure the offset component and the 1/f noise of the amplifier.

Moreover, with a configuration such that one AFE is connected to multiple pixels, in the infrared measurement mode, if an infrared detection signal that cannot be blocked leaks from the pixel selection switch of an unselected pixel and is input to the AFE so as to be superposed on an infrared detection signal of a selected pixel, it is not possible to accurately obtain infrared information of the selected pixel.

Here, by using examples of the circuit configuration of the infrared sensor element, the measurement mode switch, and the amplifier, the result of examination carried out by the inventor regarding the relationship between the circuit configuration and the leakage of the infrared detection signal will be described.

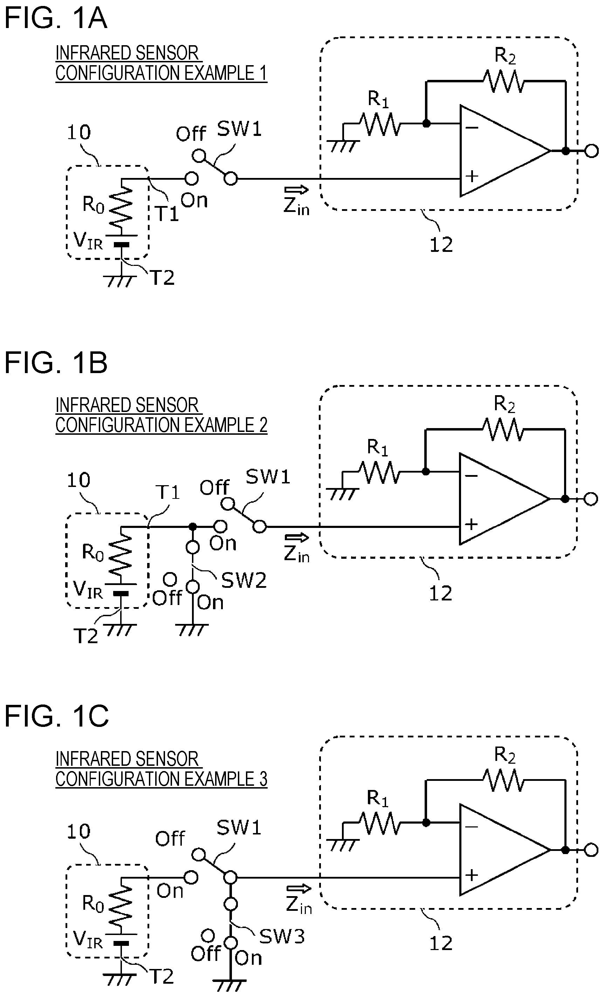

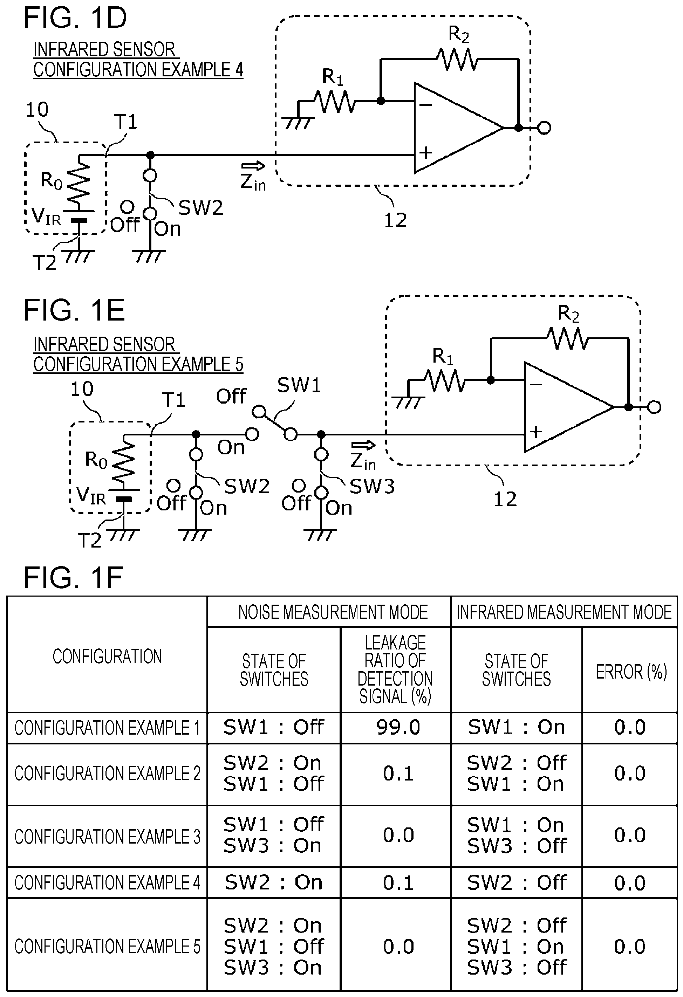

Fig. 1A illustrates the circuit configuration of an infrared sensor according to a configuration example 1. Fig. 1B illustrates the circuit configuration of an infrared sensor according to a configuration example 2. Fig. 1C illustrates the circuit configuration of an infrared sensor according to a configuration example 3. Fig. 1D illustrates the circuit configuration of an infrared sensor according to a configuration example 4. Fig. 1E illustrates the circuit configuration of an infrared sensor according to a configuration example 5. In Figs. 1A to 1E, although the switch is illustrated like a mechanical switch so that On and Off can be easily seen, the switch is a semiconductor switch in reality. The same applies to the following figures illustrating circuit configurations. In Figs. 1A to 1E, the state of switches in the noise measurement mode is illustrated.

As illustrated in Figs. 1A to 1E, the configuration examples 1 to 5 are configuration examples of an infrared sensor when one amplifier 12 is connected to one infrared sensor element 10.

As illustrated in Fig. 1A, the infrared sensor according the configuration example 1 includes one infrared sensor element 10, one serial switch SW1, and one amplifier 12. The amplifier 12 is at least a part of an AFE. The AFE may include, in addition to the amplifier 12, a filter and an AD converter, which are not illustrated in Fig. 1A. The same applies to the configuration examples 2 to 5 described below.

The infrared sensor element 10 is, for example, an infrared sensor element including a light receiver and a thermopile that thermoelectrically converts heat of the light receiver. The thermopile of the infrared sensor element 10 can be equivalently represented as a serial connection of a voltage source that generates an electromotive voltage V_{IR} and an internal resistance R₀ as illustrated in Fig. 1A. The electromotive voltage V_{IR} depends on the amount of infrared light absorbed by the light receiver. The infrared sensor element 10 outputs an infrared detection signal in accordance with the electromotive voltage V_{IR}. The internal resistance R₀ is mainly the electric resistance of a semiconductor included in the thermopile.

The thermopile of the infrared sensor element 10 includes a first terminal T1 that outputs an infrared detection signal, and a second terminal T2 that is maintained at a predetermined potential. In the illustrated example, the second terminal T2 is connected to the ground, and the predetermined potential is the ground level. In the infrared sensor element 10, the electromotive voltage V_{IR} is generated between the first terminal T1 and the second terminal T2. The second terminal T2 may be maintained at the predetermined potential as a predetermined bias voltage is applied to the second terminal T2.

The serial switch SW1 is a semiconductor switch and is, for example, a MOSFET (Metal Oxide Semiconductor Field Effect Transistor). The serial switch SW1 is connected to the infrared sensor element 10 and the amplifier 12 so that the serial switch SW1 can block transmission of an infrared detection signal from the infrared sensor element 10 to the amplifier 12. The serial switch SW1 is connected between the infrared sensor element 10 and the amplifier 12 in series with these. One end of the serial switch SW1 is connected to the first terminal T1, and the other end of the serial switch SW1 is connected to an input terminal of the amplifier 12. In the example illustrated in Fig. 1A, the other end of the serial switch SW1 is connected to a non-inverting input terminal of an operation amplifier. The serial switch SW1 switches between electrical connection and electrical disconnection between the infrared sensor element 10 and the amplifier 12. In the present specification, regarding a switch, "blockage" and "electrical disconnection" represent a state of substantial blockage and a state of substantial electrical disconnection and also include a case where electrical disconnection and blockage are incomplete and a signal leaks.

In the example illustrated in Fig. 1A, the amplifier 12 is a voltage amplifier. The voltage amplifier includes, for example, an operation amplifier and two resistors. The voltage amplifier is composed of, for example, a non-inverting amplifier circuit using an operation amplifier. The equation G = 1 + (R₂/R₁) holds, where G is the voltage gain of the non-inverting amplifier, and R₁ and R₂ are the resistances included in the voltage amplifier. The equation Zᵢₙ = Rᵢ·A₀/G holds, where Zᵢₙ is the input impedance the amplifier 12, Rᵢ is the input resistance between two input terminals of the operation amplifier, and A₀ is the open loop gain of the operation amplifier. For example, when Rᵢ = 100 MΩ, A₀ = 120 dB, and G = 1000, Zᵢₙ = 100 GΩ, and thus the input impedance of the amplifier 12 is very high.

Here, it is assumed that the resistance R_{SW1} of the serial switch SW1 has an ideal value that is infinity when the serial switch SW1 is off and is zero when the serial switch SW1 is on. In this case, in the noise measurement mode, the infrared sensor turns off the serial switch SW1 to electrically disconnect the infrared sensor element 10 and the amplifier 12. As a result, the voltage applied to the input of the amplifier 12 becomes V_{IR}·Zᵢₙ/(R₀ + R_{SW1} + Zᵢₙ) = 0, the output of the amplifier 12 does not include a component corresponding to the electromotive voltage V_{IR} due to infrared irradiation, and the offset component and the 1/f noise of the amplifier 12 are output from the amplifier 12.

In the infrared measurement mode, the infrared sensor turns on the serial switch SW1 to electrically connect the infrared sensor element 10 and the amplifier 12. As a result, the voltage applied to the input of the amplifier 12 becomes V_{IR}·Zᵢₙ/(R₀ + R_{SW1} + Zᵢₙ) ≈ V_{IR} (where R₀ « Zᵢₙ), and the amplifier 12 outputs the total sum of a signal that is the product of the electromotive voltage V_{IR} and the gain G, the offset component of the amplifier, and the 1/f noise of the amplifier. By subtracting the output value of the amplifier 12 acquired in the noise measurement mode from the output value of the amplifier 12 acquired in the infrared measurement mode, infrared information G·V_{IR}, from which the offset component and the 1/f noise of the amplifier 12 have been cancelled, is obtained.

However, in reality, the resistance R_{SW1} of the serial switch SW1 differs from the ideal value, and is not infinity when the serial switch SW1 is off. The resistance component of the serial switch SW1 depends on the dimensions and the operation speed of a switch element.

Fig. 1F is a table showing the result of calculating the leakage of an infrared detection signal in the configuration examples illustrated in Figs. 1A to 1E. Fig. 1F shows, in the rows "CONFIGURATION EXAMPLE 1" to "CONFIGURATION EXAMPLE 5" of the table, the state of switches and the leakage ratio of the infrared detection signal in the noise measurement mode, and the state of switches and the error of the infrared detection signal in the infrared measurement mode of the infrared sensors according to the configuration examples 1 to 5. In Fig. 1F, the leakage ratio of the infrared detection signal is shown in the column "LEAKAGE RATIO OF DETECTION SIGNAL (%)" and the error of the infrared detection signal is shown in the column "ERROR (%)".

The leakage ratio of the infrared detection signal in the noise measurement mode is the ratio (%) of a voltage applied to the input of the amplifier 12 to the electromotive voltage V_{IR} generated by the infrared sensor element 10 in the noise measurement mode. The error of the infrared detection signal in the infrared measurement mode is an error (%) of the voltage applied to the input of the amplifier 12 with respect the electromotive voltage V_{IR} generated by the infrared sensor element 10 in the infrared measurement mode, that is, the ratio (%) of the difference between the electromotive voltage V_{IR} generated by the infrared sensor element 10 and the voltage applied to the input of the amplifier 12 to the electromotive voltage V_{IR} generated by the infrared sensor element 10. Fig. 1F shows the leakage ratio of the infrared detection signal and the error of the infrared detection signal that are calculated when it is assumed that the resistance of each of the serial switch SW1 and parallel switches SW2 and SW3 described below is 1 GΩ when they are off and is 100 Ω when they are on, and the input impedance Zᵢₙ of the amplifier 12 is 100 GΩ.

As shown in the row "CONFIGURATION EXAMPLE 1" of Fig. 1F, in the infrared sensor according to the configuration example 1, the leakage ratio of the infrared detection signal is 99.0%, and the voltage applied to the input of the amplifier 12 in the noise measurement mode is as high as 99.0% of the electromotive voltage V_{IR}. On the other hand, in the infrared sensor according the configuration example 1, the error of the infrared detection signal is 0.0%, and, in the infrared measurement mode, the electromotive voltage V_{IR} and the voltage of the error 0.0% are applied to the input of the amplifier 12. In this way, in the noise measurement mode, a large amount of infrared detection signal leaks and is applied to the input of the amplifier 12 in the infrared sensor according the configuration example 1 illustrated in Fig. 1A. Therefore, even by calculating the difference in the output of the amplifier 12 between the infrared measurement mode and the noise measurement mode, it is not possible to accurately cancel the offset component and the 1/f noise of the amplifier 12. This is due to the fact that the resistance of the serial switch SW1 when it is off is not ideal infinity and does not even have a sufficiently high value compared with the input impedance Zᵢₙ of the amplifier 12.

Next, an infrared sensor according to the configuration example 2 will be described. As illustrated in Fig. 1B, the infrared sensor according to the configuration example 2 has a configuration such that a parallel switch SW2 is added to the configuration of the infrared sensor according to the configuration example 1.

The parallel switch SW2 is a semiconductor switch and is, for example, a MOSFET. The parallel switch SW2 connects the first terminal T1 and the second terminal T2 of the infrared sensor element 10 so that the parallel switch SW2 is capable of short-circuiting the first terminal T1 and the second terminal T2. The parallel switch SW2 is connected between the infrared sensor element 10 and the serial switch SW1 in parallel with the infrared sensor element 10. One end of the parallel switch SW2 is connected to the first terminal T1 and one end of the serial switch SW1, and the other end of the parallel switch SW2 is connected to the ground as with the second terminal T2. The other end of the parallel switch SW2 and the second terminal T2 are electrically connected through the common ground. Therefore, the other end of the parallel switch SW2 is connected also to the second terminal T2. When the parallel switch SW2 is on, the first terminal T1 and the second terminal T2 of the infrared sensor element 10 are short-circuited.

As shown in Fig. 1F, in the noise measurement mode, the infrared sensor according to the configuration example 2 turns off the serial switch SW1, and turns on the parallel switch SW2. Thus, in the noise measurement mode, the infrared sensor element 10 is short-circuited by the parallel switch SW2. In the infrared measurement mode, the infrared sensor according to the configuration example 2 turns on the serial switch SW1, and turns off the parallel switch SW2. Thus, an infrared detection signal from the infrared sensor element 10 is input to the amplifier 12.

As a result of such an operation, as shown in the row "CONFIGURATION EXAMPLE 2" of Fig. 1F, the leakage ratio of the infrared detection signal in the noise measurement mode is 0.1%, which is an improvement from the configuration example 1. This is because the infrared sensor element 10 is short-circuited since the parallel switch SW2 is on, and the infrared detection signal does not easily leak from the infrared sensor element 10. The error of the infrared detection signal in the infrared measurement mode is 0.0%. Therefore, it is possible to cancel the offset component and the 1/f noise of the amplifier 12 by calculating the difference in the output of the amplifier 12 between the infrared measurement mode and the noise measurement mode.

Next, an infrared sensor according to the configuration example 3 will be described. As illustrated in Fig. 1C, the infrared sensor according to the configuration example 3 has a configuration such that a parallel switch SW3 is added to the configuration of the infrared sensor according to the configuration example 1.

The parallel switch SW3 is a semiconductor switch and is, for example, a MOSFET. The parallel switch SW3 connects the input terminal of the amplifier 12 and the reference potential so that the parallel switch SW3 is capable of short-circuiting the input terminal of the amplifier 12 and the reference potential. The parallel switch SW3 is connected between the serial switch SW1 and the amplifier 12 in parallel with the infrared sensor element 10. One end of the parallel switch SW3 is connected to the other end of the serial switch SW1 and the input terminal of the amplifier 12, and the other end of the parallel switch SW3 is connected to the ground. In the example illustrated in Fig. 1C, one end of the parallel switch SW3 is connected to the non-inverting input terminal of an operation amplifier. The parallel switch SW3 switches between electrical connection and electrical disconnection between the input terminal of the amplifier 12 and the ground. When the parallel switch SW3 is on, the input terminal of the amplifier 12 is connected to the ground level that is the reference potential. The reference potential is not limited to the ground level and can be set to have any appropriate predetermined value. For example, when the amplifier 12 is to be unipolarly driven, the reference potential may have a value that is approximately a half of the drive DC (Direct Current) voltage of the amplifier 12.

As shown in Fig. 1F, in the noise measurement mode, the infrared sensor according to the configuration example 3 turns off the serial switch SW1, and turns on the parallel switch SW3. Thus, in the noise measurement mode, the input terminal of the amplifier 12 and the reference potential are short-circuited by the parallel switch SW3. In the infrared measurement mode, the infrared sensor according to the configuration example 3 turns on the serial switch SW1, and turns off the parallel switch SW3. Thus, an infrared detection signal from the infrared sensor element 10 is input to the amplifier 12.

As a result of such an operation, as shown in the row "CONFIGURATION EXAMPLE 3" of Fig. 1F, the leakage ratio of the infrared detection signal in the noise measurement mode is 0.0%, which is an improvement from the configuration example 1. This is because the input terminal of the amplifier 12 and the reference potential are short-circuited since the parallel switch SW3 is on, and an infrared detection signal that has leaked from the infrared sensor element 10 does not easily affect the amplifier 12. The error of the infrared detection signal in the infrared measurement mode is 0.0%. Therefore, it is possible to cancel the offset component and the 1/f noise of the amplifier 12 by calculating the difference in the output of the amplifier 12 between the infrared measurement mode and the noise measurement mode.

Next, an infrared sensor according to the configuration example 4 will be described. As illustrated in Fig. 1D, the infrared sensor according to the configuration example 4 has a configuration such that the serial switch SW1 is removed from the configuration of the infrared sensor according to the configuration example 2 and only the parallel switch SW2 is disposed as a switch connected to the infrared sensor element 10.

In the infrared sensor according to the configuration example 4, because the serial switch SW1 is removed, one end of the parallel switch SW2 is connected not to one end of the serial switch SW1 but to the input terminal of the amplifier 12. Therefore, the parallel switch SW2 also has a function similar to that of the parallel switch SW3, and also functions to switch between electrical connection and electrical disconnection between the input terminal of the amplifier 12 and the ground.

As shown in Fig. 1F, in the noise measurement mode, the infrared sensor according to the configuration example 4 turns on the parallel switch SW2. Thus, the second terminal T2 of the infrared sensor element 10 and the input terminal of the amplifier 12 are connected to the reference potential (the ground level in the example shown in Fig. 1F). Moreover, the first terminal T1 and the second terminal T2 are short-circuited. In the infrared measurement mode, the infrared sensor according to the configuration example 4 turns off the parallel switch SW2. Thus, an infrared detection signal from the infrared sensor element 10 is input to the amplifier 12.

As a result of such an operation, as shown in the row "CONFIGURATION EXAMPLE 4" of Fig. 1F, the leakage ratio of the infrared detection signal in the noise measurement mode is 0.1%, which is an improvement from the configuration example 1. The reason for this is the same as that described in the configuration example 2 and the configuration example 3. The error of the infrared detection signal in the infrared measurement mode is 0.0%. Therefore, it is possible to cancel the offset component and the 1/f noise of the amplifier 12 by calculating the difference in the output of the amplifier 12 between the infrared measurement mode and the noise measurement mode.

Next, an infrared sensor according to the configuration example 5 will be described. As illustrated in Fig. 1E, the infrared sensor according to the configuration example 5 has a configuration such that: the parallel switch SW2 and the parallel switch SW3 are added to the configuration of the infrared sensor according to the configuration example 1; and the parallel switch SW2, the serial switch SW1, and the parallel switch SW3 are connected in a π-shape.

The infrared sensor according to the configuration example 5 performs an operation that is a combination of the operation of the infrared sensor according to the configuration example 2 and the operation of the infrared sensor according to the configuration example 3. To be specific, as shown in Fig. 1F, in the noise measurement mode, the infrared sensor according to the configuration example 5 turns on the parallel switch SW2, turns off the serial switch SW1, and turns on the parallel switch SW3. In the infrared measurement mode, the infrared sensor according to the configuration example 5 turns off the parallel switch SW2, turns on the serial switch SW1, and turns off the parallel switch SW3.

As a result of such an operation, as shown in the row "CONFIGURATION EXAMPLE 5" of Fig. 1F, the leakage ratio of the infrared detection signal in the noise measurement mode is 0.0%, which is an improvement from the configuration example 1. The reason for this is the same as that described in the configuration example 2 and the configuration example 3. The error of the infrared detection signal in the infrared measurement mode is 0.0%. Therefore, it is possible to cancel the offset component and the 1/f noise of the amplifier 12 by calculating the difference in the output of the amplifier 12 between the infrared measurement mode and the noise measurement mode.

From the above, it has been shown that it is possible to solve the problem of the configuration of the infrared sensor according to the configuration example 1, which arises due to the fact that the resistance value of a semiconductor switch when it is off is not ideal infinity, by using the configurations of the infrared sensors according to the configuration examples 2 to 5 in which at least one of the parallel switch SW2 and the parallel switch SW3 is used. The inventor focused on the fact that the aforementioned problem of the leakage of the infrared detection signal and decrease of the detection accuracy of the infrared sensor arises due to the characteristics of a semiconductor switch and the fact that improvement can be made by appropriately configuring a switch used for the infrared sensor.

Moreover, the inventor examined application of the above examination result to an infrared sensor including multiple infrared sensor elements 10. When the infrared sensor element 10 includes multiple infrared sensor elements 10, by connecting the infrared sensor elements 10 and the amplifier 12 many-to-one, it is possible to restrict current consumption needed to drive the amplifier 12 because amplifiers 12 in the same number as the pixels (the infrared sensor elements 10) are not necessary. That is, the pixels are allotted to one amplifier 12 by time-sharing. Therefore, scanning of pixels is performed by switching the pixel selection switch over a certain time, and, in view of current consumption of the amplifier 12, it is desirable to connect the infrared sensor elements 10 and the amplifier 12 many-to-one as long as the number of imaging frames necessary for one second can be reliably achieved.

However, with the configuration such that the infrared sensor elements 10 and the amplifier 12 are connected many-to-one, it is expected that, in the noise measurement mode, infrared detection signals that leak from a large number of infrared sensor elements 10 are superposed on each other and easily transmitted to the amplifier 12. Moreover, it is expected that, in the infrared measurement mode, infrared detection signals that have leaked from a large number of infrared sensor elements 10 other than selected infrared sensor elements 10 are superposed on each other and easily transmitted to the amplifier 12.

The inventor has achieved an aspect of the present disclosure by examining application of the examination result of the switch configuration in the circuit configurations described above to an infrared sensor including multiple infrared sensor elements 10. Moreover, the inventor has achieved an aspect of the present disclosure by examining an amplifier as a measure against the leakage of the infrared detection signal. Hereafter, details will be described.

### (Overview of Present Disclosure)

Hereafter, examples of an infrared sensor according to the present disclosure will be described.

An infrared sensor according to a first aspect of the present disclosure includes a substrate, a sensor element that generates an infrared detection signal, a first switch that is connected to the sensor element, and an amplifier that amplifies the infrared detection signal generated by the sensor element. The sensor element includes a light receiver that is positioned above the substrate, a floating supporter that joins the substrate and the light receiver and supports the light receiver in a floating manner so that a gap is formed between the substrate and the light receiver, and a thermoelectric converter that generates the infrared detection signal based on heat generated by the light receiver. The thermoelectric converter includes a first terminal that outputs the infrared detection signal and a second terminal that is maintained at a predetermined potential. The first switch connects the first terminal and the second terminal so that the first switch is capable of short-circuiting the first terminal and the second terminal. The amplifier is a current-input amplifier.

Thus, when the infrared detection signal from the sensor element is not to be output to the amplifier, by short-circuiting the thermoelectric converter by using the first switch, the infrared detection signal generated by the sensor element is not easily output to the amplifier. Therefore, an error is not easily generated in the output from the amplifier when the infrared detection signal from the sensor element is not output to the amplifier. As a result, for example, in the noise measurement mode, it is possible to measure the offset component and the 1/f noise of the amplifier by reducing the effect of the leakage of the infrared detection signal from the sensor element. Thus, with the infrared sensor according to the present aspect, it is possible to increase the infrared detection accuracy.

Moreover, because the amplifier is a current-input amplifier having a low input impedance, when the first switch is changed from on to off to switch the measurement mode from the noise measurement mode to the infrared measurement mode, a current having substantially the same magnitude as a short-circuit current that has been flowing through the thermoelectric converter of the sensor element in the noise measurement mode flows from the sensor element to the amplifier in the infrared measurement mode. Therefore, for example, because the magnitude of the current that flows through the thermoelectric converter of the sensor element does not substantially change before and after the switching, the Peltier effect opposite to the Seebeck effect does not easily change in the thermoelectric converter, and the temperature distribution in the thermoelectric converter does not substantially change. Accordingly, even when the infrared information that is output from the amplifier immediately after the switching is read, an error that is generated in the process of redistribution of the temperature distribution is not generated, and a good S/N can be reliably achieved. Thus, the infrared sensor according to the present aspect can perform high-accuracy and high-speed detection operation.

For example, an infrared sensor according to a second aspect of the present disclosure is the infrared sensor according to the first aspect, including sensor elements each of which is identical to the sensor element; and first switches each of which is identical to the first switch. The infrared sensor further includes second switches that are connected one-to-one to the sensor elements. Each of the second switches is a semiconductor switch and individually switches between electrical connection and electrical disconnection between a corresponding one of the sensor elements and the amplifier.

In the present aspect, the second switches for selecting the sensor elements that output the infrared detection signals to the amplifier are semiconductor switches, the resistance of each of the second switches is not ideal infinity even when the second switch is off, and the infrared detection signals leak from the sensor elements that are not selected. Even in such a case, because the first switch is connected to each of the sensor elements and the amplifier is a current-input amplifier, in the same way as described above, an error is not easily generated in the output from the amplifier when the infrared detection signals from the sensor elements are not output to the amplifier. As a result, for example, in the noise measurement mode, it is possible to measure the offset component and the 1/f noise of the amplifier by reducing the effect of the leakage of the infrared detection signals from the sensor elements. Moreover, for example, in the infrared measurement mode, the effect of the leakage of the infrared detection signals from unselected sensor elements can be reduced, and it is possible to measure the infrared detection signals of selected sensor elements. Thus, with the infrared sensor according to the present aspect, it is possible to increase the infrared detection accuracy.

For example, an infrared sensor according to a third aspect of the present disclosure is the infrared sensor according to the second aspect, further including a control circuit that causes, by simultaneously setting two or more of the second switches to an electrically connecting state, two or more of the sensor elements that are connected to the two or more second switches to simultaneously output the infrared detection signals to the amplifier.

Thus, because the infrared detection signals from the two or more sensor elements are added and input to the amplifier, it is possible to increase the output from the amplifier. Therefore, for example, even if an infrared detection signal generated by one sensor element is weak, the infrared detection signal is intensified, and it is possible to improve S/N.

For example, an infrared sensor according to a fourth aspect of the present disclosure is the infrared sensor according to any one of the first to third aspects, in which at least a part of the thermoelectric converter is provided in the floating supporter, and the floating supporter has a phononic crystal structure.

Due to heat insulating properties of the phononic crystal structure of the floating supporter, the heat of the light receiver, whose temperature has changed by being irradiated with infrared light, does not easily dissipate, and thus the infrared detection sensitivity of the thermoelectric converter is improved. On the other hand, when the floating supporter has the phononic crystal structure, the heat resistance of the floating supporter increases due to high heat insulating properties of the phononic crystal structure. As a result, the thermal time constant of a thermal circuit composed of the floating supporter and the light receiver increases, and it takes a long time for redistribution of the temperature distribution in the floating supporter in which the thermoelectric converter is provided. However, when the measurement mode is switched from the noise measurement mode to the infrared measurement mode, the Peltier effect opposite to the Seebeck effect does not easily change as described above, and, before and after the switching, the temperature distribution in the thermal circuit composed of the floating supporter, in which the thermoelectric converter is provided, and the light receiver does not substantially change. Therefore, increase of the thermal time constant due to the phononic crystal structure does not easily degrade S/N and high-speed detection operation.

An infrared sensor according to a fifth aspect of the present disclosure includes a substrate, sensor elements each of which generates an infrared detection signal, first switches that are connected one-to-one to the sensor elements, an amplifier that amplifies the infrared detection signals generated by the sensor elements, second switches that are connected one-to-one to the sensor elements and each of which individually switches between electrical connection and electrical disconnection between a corresponding one of the sensor elements and the amplifier, and a third switch that is connected to an input terminal of the amplifier and that is capable of short-circuiting the input terminal to a reference potential. Each of the sensor elements includes a light receiver that is positioned above the substrate, a floating supporter that joins the substrate and the light receiver and supports the light receiver in a floating manner so that a gap is formed between the substrate and the light receiver, and a thermoelectric converter that generates the infrared detection signal based on heat generated by the light receiver. The thermoelectric converter includes a first terminal that outputs the infrared detection signal and a second terminal that is maintained at a predetermined potential. Each of the first switches connects the first terminal and the second terminal so that the first switch is capable of short-circuiting the first terminal and the second terminal. Each of the second switches is a semiconductor switch. The amplifier is a voltage-input amplifier.

In the present aspect, the second switches for selecting the sensor elements that output the infrared detection signals to the amplifier are semiconductor switches, the resistance of each of the second switches is not ideal infinity even when the second switches are off, and the infrared detection signals leak from the sensor elements that are not selected. Even in such a case, when the infrared detection signals from the sensor elements are not to be output to the amplifier, by short-circuiting the thermoelectric converters by using the first switches, the infrared detection signals generated by the sensor elements are not easily output to the amplifier. Moreover, even if the infrared detection signals leak from the sensor elements to the amplifier, because the third switch can short-circuit the input terminal of the amplifier to the reference potential, the leaked infrared detection signals do not easily affect the input of the amplifier. Therefore, an error is not easily generated in the output from the amplifier when the infrared detection signals from the sensor elements are not output to the amplifier. As a result, for example, in the noise measurement mode, it is possible to measure the offset component and the 1/f noise of the amplifier by reducing the effect of the leakage of the infrared detection signals from the sensor elements. Moreover, for example, in the infrared measurement mode, the effect of the leakage of the infrared detection signals from unselected sensor elements can be reduced, and it is possible to measure the infrared detection signals of selected sensor elements. Thus, with the infrared sensor according to the present aspect, it is possible to increase the infrared detection accuracy.

Hereafter, embodiments of the present disclosure will be described with reference to the drawings.

The embodiments described below are each a general or specific example. The values, shapes, materials, elements, arrangements of elements, connection configurations of elements, steps, order of steps, and the like described in the following embodiments are examples, and do not limit the present disclosure. Among the elements in the embodiments, elements that are not described in independent claims are optional elements.

Each figure is a schematic view, and is not necessarily drawn strictly. Accordingly, for example, the scales and the like do not necessarily coincide with each other between the figures. In the figures, configurations that are substantially the same are denoted by the same numerals, and redundant descriptions will be omitted or simplified.

In the present specification, terms that represent the relationships between elements, terms that represent the shapes of elements such as rectangular, and the numerical ranges not only have strict meanings but also have meanings in substantially the equivalent range with a difference of, for example, about several percents.

In the present specification, the terms "above" and "below" do not represent the upward direction (vertically above) and the downward direction (vertically below) in absolute spatial recognition, but are used as terms that are defined by a relative positional relationship. To be specific, the receiving side of an infrared sensor is defined as "above" and a side opposite to the receiving side is defined as "below". The terms "above", "below", and the like are used to indicate relative arrangement of members and are not intended to limit a posture when the infrared sensor is used. The terms "above" and "below" are used, not only when two elements are disposed with a space therebetween and another element exists between the two elements, but also when two elements are disposed very close to each other and the two elements are in contact with each other.

In the present specification, unless otherwise noted, "plan view" refers to a view that is seen from a direction perpendicular to an upper surface of a semiconductor substrate (that is, the thickness direction of the semiconductor substrate).

In the present specification, unless otherwise noted, an ordinal number, such as "first" or "second", does not mean the number of elements or the order of elements, and is used to avoid confusion between similar elements and to discriminate between the elements.

### (First Embodiment)

Hereafter, an infrared sensor according to a first embodiment will be described.

### [Overall Configuration]

First, the overall configuration of the infrared sensor according to the first embodiment will be described.

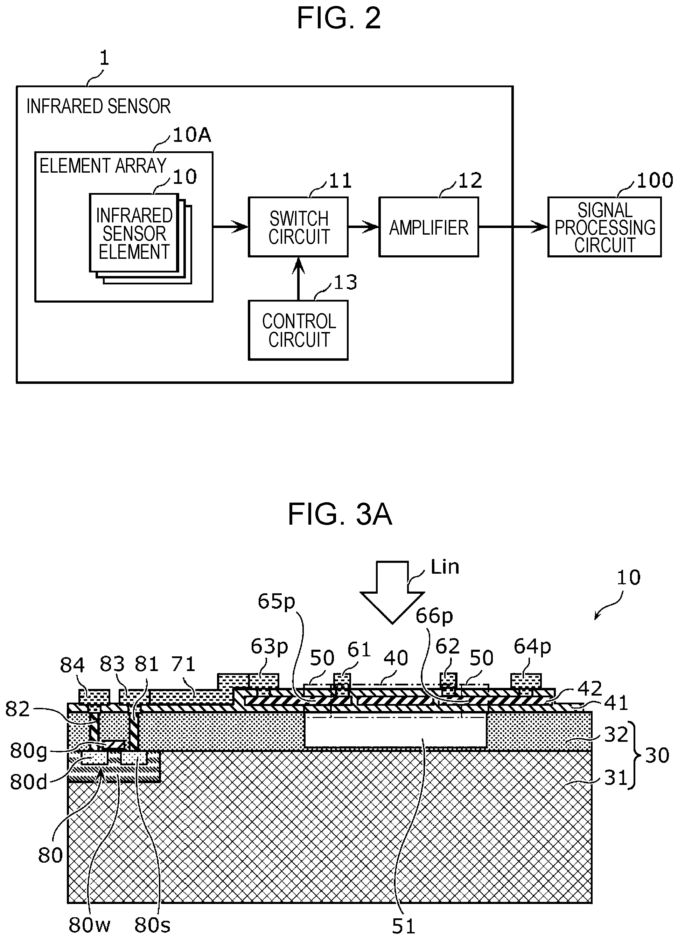

Fig. 2 is a block diagram illustrating the overall configuration of an infrared sensor 1 according to the first embodiment.

As illustrated in Fig. 2, the infrared sensor 1 includes an element array 10A composed of infrared sensor elements 10, a switch circuit 11, an amplifier 12, and a control circuit 13. The infrared sensor elements 10 are each an example of a sensor element. The infrared sensor 1 is, for example, an infrared image sensor (infrared imaging device) in which the infrared sensor elements 10 are arranged as pixels. The infrared sensor 1 is, for example, an infrared sensor chip that is formed on one substrate 30 described below. A part of the infrared sensor 1 may be formed on another substrate. For example, at least one of the amplifier 12 and the control circuit 13 may be formed on a substrate that is different from the substrate 30 on which the element array 10A and the switch circuit 11 are formed.

The element array 10A is composed of the infrared sensor elements 10 that are arrayed on the same substrate 30. In the block diagram of Fig. 2, for convenience, the infrared sensor elements 10 are illustrated to overlap. However, in reality, the infrared sensor elements 10 are arrayed in multiple columns and rows in the vertical and horizontal directions in plan view. Each of the infrared sensor elements 10 generates an infrared detection signal in accordance with the amount of received infrared light and outputs the generated infrared detection signal. In the present embodiment, the number of the infrared sensor elements 10 is N (where N is an integer greater than or equal to 2).

The switch circuit 11 is a circuit that includes switches and wiring and connects the element array 10A and the amplifier 12. By turning on and off the switches of the switch circuit 11, switching of the measurement mode between the noise measurement mode and the infrared measurement mode, scanning of pixels, and the like are performed. Detailed configuration of the switch circuit 11 will be described below.

The amplifier 12 amplifies infrared detection signals generated by the infrared sensor elements 10. The amplifier 12 is a voltage-input amplifier having a high input impedance. The amplifier 12 is, for example, a voltage amplifier (voltage-input voltage-output amplifier). However, as long as the amplifier 12 is an active element having a high input impedance, the amplifier 12 is not limited to a voltage amplifier, and may be a transconductance amplifier (voltage-input current-output amplifier) or a voltage follower (an amplifier having a gain of one). The amplifier 12 is, for example, a part of an AFE. Although not illustrated, the infrared sensor 1 may include, instead of the amplifier 12, a filter and an AD converter included in an AFE. The amplifier 12 outputs an amplified infrared detection signal. The output from the amplifier 12 is input to, for example, a signal processing circuit 100. The output information from the amplifier 12 may be converted into encoded digital information by an AD converter.

The control circuit 13 controls the entirety of the infrared sensor 1. For example, the control circuit 13 controls the operation of a switch of the switch circuit 11 by outputting a control signal. For example, the control circuit 13 supplies a control signal (for example, a high-level or low-level voltage) for controlling the operation of a switch of the switch circuit 11 described below to a control terminal (for example, the gate) of the switch. The control circuit 13 may output a control signal for controlling an AFE. For example, the control circuit 13 causes the infrared sensor 1 to operate in the infrared measurement mode and the noise measurement mode, and causes the amplifier 12 to output output information in each of the infrared measurement mode and the noise measurement mode. The infrared sensor 1 need not include the control circuit 13, and the infrared sensor 1 may be controlled by an external control device having the function of the control circuit 13.

The control circuit 13 includes, for example, one or more microcomputers, processors, or the like storing programs for performing control processing of the infrared sensor 1. The control circuit 13 may include a dedicated logic circuit that performs control processing of the infrared sensor 1.

The signal processing circuit 100 performs various signal processing on the output from the amplifier 12. The signal processing circuit 100 performs, for example, processing for cancelling (removing) the offset component and the 1/f noise of the amplifier 12 from the output information in the infrared measurement mode by calculating the difference in the output information of the amplifier 12 (AFE) between the infrared measurement mode and the noise measurement mode.

The signal processing circuit 100 includes, for example, one or more microcomputers, processors, or the like storing programs for performing control processing. The signal processing circuit 100 may include a dedicated logic circuit that performs signal processing.

The signal processing circuit 100 is included in, for example, an external signal processing device. However, the signal processing circuit 100 may be included in the infrared sensor 1. When the signal processing circuit 100 is included in the infrared sensor 1, the control circuit 13 and the signal processing circuit 100 may be implemented in one microcomputer or processor, or each may be implemented in one or more independent microcomputers or processors.

### [Infrared Sensor Element]

Next, the detailed configuration of an infrared sensor element 10 included in the infrared sensor 1 will be described.

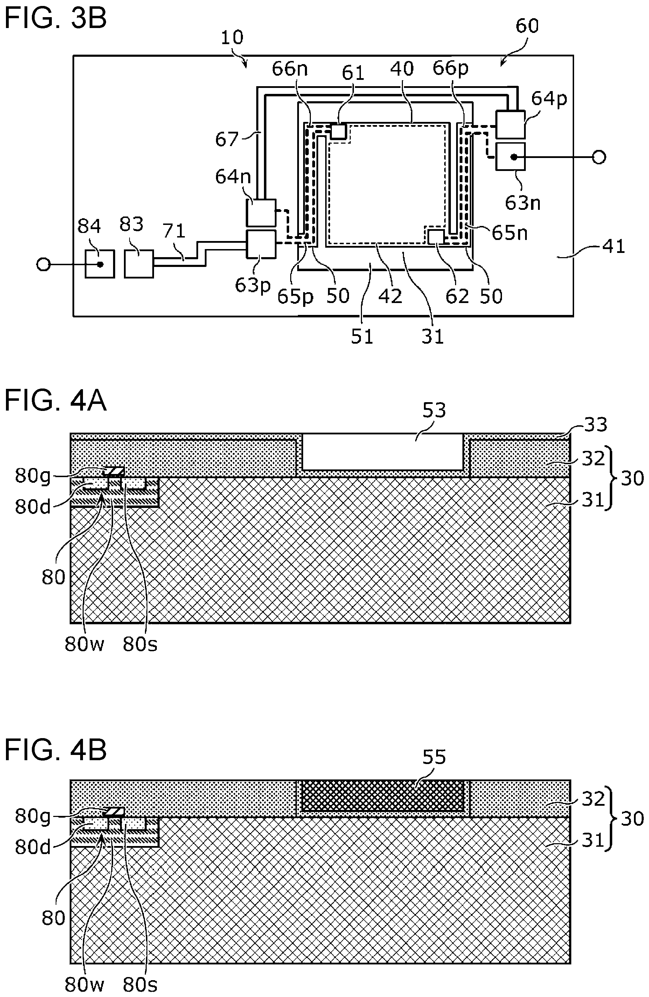

Fig. 3A is a sectional view illustrating the infrared sensor element 10 according to the first embodiment. Fig. 3B is a plan view illustrating the infrared sensor element 10 according to the first embodiment as seen from above. Figs. 3A and 3B illustrate, in addition to the infrared sensor element 10, the substrate 30 and a transistor 80 that is a switch of the switch circuit 11. Although Figs. 3A and 3B illustrate one infrared sensor element 10, other infrared sensor elements 10 included in the element array 10A are also arrayed on the same substrate 30 in plan view. Fig. 3A is a sectional view of the structure illustrated in Fig. 3B taken along a line that passes through metal wiring 84, metal wiring 83, metal wiring 71, a cold-junction metal electrode 63p, a P-type semiconductor 65p, a hot-junction metal electrode 61, a hot-junction metal electrode 62, a P-type semiconductor 66p, and a cold-junction metal electrode 64p in this order. In Fig. 3B, the positions of N-type semiconductors 65n and 66n and P-type semiconductors 65p and 66p, which are covered by an insulating film 41 in reality, are shown by thick broken lines. In Fig. 3B, the outline of a semiconductor 42 of a light receiver 40, which is covered by the insulating film 41 in reality, is shown by a broken line.

As illustrated in Figs. 3A and 3B, the infrared sensor element 10 includes the light receiver 40, a floating supporter 50, and a thermoelectric converter 60. The infrared sensor element 10 is positioned above the substrate 30. For example, at least a part of the infrared sensor element 10 is formed on the substrate 30. For example, all of the infrared sensor elements 10 included in the infrared sensor 1 have the same configuration.

The substrate 30 is a substrate for forming the infrared sensor elements 10, peripheral circuits, and the like thereon. The substrate 30 includes a semiconductor substrate 31 and an insulating film 32 that is stacked on an upper surface of the semiconductor substrate 31.

The semiconductor substrate 31 is, for example, a silicon substrate. However, the semiconductor substrate 31 may be a semiconductor substrate other than a silicon substrate. The transistor 80 is formed on the upper surface of the semiconductor substrate 31.

The transistor 80 is a MOSFET. The transistor 80 includes a source 80s, a drain 80d, a gate 80g, and a well 80w. A gate oxide film is disposed between the gate 80g, which is a conductive layer, and a channel region of the transistor 80. The transistor 80 need not include the well 80w, depending on the type and the concentration of an impurity in the semiconductor substrate 31.

The transistor 80 is one of the switches of the switch circuit 11. In the present embodiment, the transistor 80 is a serial switch SW1 provided between the infrared sensor element 10 and the amplifier 12 or a parallel switch SW2 for short-circuiting the infrared sensor element 10. In addition to the transistor 80, a MOSFET as a switch of the switch circuit 11 may be formed on the semiconductor substrate 31. The MOSFET, which may be formed on the semiconductor substrate 31 in addition to the transistor 80, may function as a non-switch component of the switch circuit 11, and may have, for example, a logic function of selecting pixels or a function of amplifying a detection signal.

The insulating film 32 is positioned above the semiconductor substrate 31, to be more specific, on the upper surface of the semiconductor substrate 31. The insulating film 32 is made of, for example, an oxide such as silicon oxide (SiO₂). However, the insulating film 32 may be made of an insulating material other than silicon oxide.

The light receiver 40 generates heat by absorbing infrared light, and the temperature of the light receiver 40 increases due to the heat. Infrared incident light Lᵢₙ is incident on the infrared sensor element 10 from above, and at least a part of the infrared incident light Lᵢₙ is absorbed by the light receiver 40. The amount of heat generated by the light receiver 40 depends on the amount of infrared light absorbed by the light receiver 40.

The light receiver 40 is positioned above the substrate 30. The light receiver 40 has a two-dimensional spread. The light receiver 40 has, for example, a square shape in plan view. However, the light receiver 40 may have another shape such as a rectangular shape. The light receiver 40 is separated from the substrate 30, and a gap 51 is formed between the light receiver 40 and the substrate 30.

In the present embodiment, the light receiver 40 includes a part of the insulating film 41 and a part of the semiconductor 42 having a thin film-like shape. The light receiver 40 has a structure such that the semiconductor 42 is sandwiched by the insulating film 41.

The insulating film 41 and the semiconductor 42 are disposed above the substrate 30. The insulating film 41 is formed on the gap 51 and on the insulating film 32. The semiconductor 42 is sandwiched by the insulating film 41 from above and below. The N-type semiconductors 65n and 66n and the P-type semiconductors 65p and 66p described below are each formed in a part of the semiconductor 42. The insulating film 41 is made of, for example, silicon nitride (SiN). However, the insulating film 41 may be made of an insulating material other than silicon nitride (such as silicon oxide). The semiconductor 42 is, for example, polycrystalline silicon. However, the semiconductor 42 may be a semiconductor other than polycrystalline silicon.

The floating supporter 50 supports the light receiver 40 in a floating manner so that the gap 51 is formed between the substrate 30 and the light receiver 40. The gap 51 is positioned between the substrate 30, and the light receiver 40 and the floating supporter 50. In the present embodiment, the floating supporter 50 is composed of two arms that join the light receiver 40 and the insulating film 32. The floating supporter 50 includes a part of the insulating film 41, and the N-type semiconductors 65n and 66n and the P-type semiconductors 65p and 66p, each of which is a part of the semiconductor 42. A side wall of the gap 51 is formed by the insulating film 32. The gap 51 is, for example, a recess that is formed in the substrate 30 by removing a part of the insulating film 32. Even though the gap 51 is formed by removing a part of the insulating film 32 below the light receiver 40 in this way, the light receiver 40 is supported in a floating manner by the floating supporter 50. The gap 51 suppresses transfer of heat from the light receiver 40 to the substrate 30, and suppresses decrease of the temperature of the light receiver 40, which has increased by receiving infrared light.

The thermoelectric converter 60 generates an infrared detection signal based on heat generated by the light receiver 40. The infrared detection signal is, for example, a voltage signal or a current signal. At least a part of the thermoelectric converter 60 is provided in the floating supporter 50. In the present embodiment, the thermoelectric converter 60 is a thermopile-type thermoelectric conversion device using the Seebeck effect. The thermoelectric converter 60 includes hot-junction metal electrodes 61 and 62, cold-junction metal electrodes 63p, 63n, 64p, and 64n, the N-type semiconductors 65n and 66n, the P-type semiconductors 65p and 66p, and metal wiring 67.

The hot-junction metal electrodes 61 and 62 are positioned on the light receiver 40. The hot-junction metal electrodes 61 and 62 are positioned in the vicinity of the connection portion between the light receiver 40 and the floating supporter 50. The hot-junction metal electrodes 61 and 62 may be at any positions where the temperature thereof changes in synchronism with the temperature of the light receiver 40. For example, the hot-junction metal electrodes 61 and 62 may be positioned adjacent to the light receiver 40.

The cold-junction metal electrodes 63p, 63n, 64p, and 64n are positioned outside of the light receiver 40 in plan view. The cold-junction metal electrodes 63p, 63n, 64p, and 64n are positioned outside of the gap 51 in plan view. The cold-junction metal electrodes 63p, 63n, 64p, and 64n are positioned in the vicinity of the connection portion between the substrate 30 and the floating supporter 50. The hot-junction metal electrode 61 and the cold-junction metal electrodes 63p and 64n are disposed with one of the arms of the floating supporter 50 therebetween. The hot-junction metal electrode 62 and the cold-junction metal electrodes 63n and 64p are disposed with the other arm of the floating supporter 50 therebetween.

The N-type semiconductors 65n and 66n and the P-type semiconductors 65p and 66p are each provided in the insulating film 41. The N-type semiconductors 65n and 66n and the P-type semiconductors 65p and 66p each have a linear shape extending along the floating supporter 50. The N-type semiconductor 66n and the P-type semiconductor 65p pass through one of the arms of the floating supporter 50. The N-type semiconductor 65n and the P-type semiconductor 66p pass through the other arm of the floating supporter 50. The N-type semiconductors 65n and 66n and the P-type semiconductors 65p and 66p are each formed by doping the semiconductor 42 with an impurity (such as boron (B) or phosphor (P)).

One end of the N-type semiconductor 66n and one end of the P-type semiconductor 65p are in contact with the hot-junction metal electrode 61 and are connected to the hot-junction metal electrode 61. The N-type semiconductor 66n and the P-type semiconductor 65p form a hot junction by being electrically connected via the hot-junction metal electrode 61. One end of the N-type semiconductor 65n and one end of the P-type semiconductor 66p are in contact with the hot-junction metal electrode 62 and are connected to the hot-junction metal electrode 62. The N-type semiconductor 65n and the P-type semiconductor 66p form a hot junction by being connected via the hot-junction metal electrode 62.

The other end of the P-type semiconductor 65p is in contact with the cold-junction metal electrode 63p, and forms a cold junction by being connected to the cold-junction metal electrode 63p. The other end of the N-type semiconductor 66n is in contact with the cold-junction metal electrode 64n, and forms a cold junction by being connected to the cold-junction metal electrode 64n. The other end of the P-type semiconductor 66p is in contact with the cold-junction metal electrode 64p, and forms a cold junction by being connected to the cold-junction metal electrode 64p. The other end of the N-type semiconductor 65n is in contact with the cold-junction metal electrode 63n, and forms a cold junction by being connected to the cold-junction metal electrode 63n.

Connections of the N-type semiconductors 65n and 66n and the P-type semiconductors 65p and 66p to the hot-junction metal electrodes 61 and 62 and to the cold-junction metal electrodes 63p, 63n, 64p, and 64n are ohmic connections. The N-type semiconductor 66n and the P-type semiconductor 65p, which are ohmically connected to the same hot-junction metal electrode 61, constitute a thermocouple. The N-type semiconductor 65n and the P-type semiconductor 66p, which are ohmically connected to the same hot-junction metal electrode 62, constitute a thermocouple.

When the light receiver 40 absorbs infrared light and consequently the temperature of the hot junction becomes higher than the temperature of the cold junction, a large number of carriers gather on the cold junction side. As a result, the cold junction of the N-type semiconductors 65n and 66n has a negative electromotive voltage with respect to the cold junction of the P-type semiconductors 65p and 66p. In the illustrated example, there are two pairs of cold junctions and hot junctions, and the metal wiring 67 electrically connects the cold-junction metal electrode 64n and the cold-junction metal electrode 64p. Therefore, two thermocouples each having an electromotive voltage are connected in series, and the cold-junction metal electrode 63n has a negative electromotive voltage with respect to the cold-junction metal electrode 63p. That is, a potential difference in accordance with heat generated by the light receiver 40 is generated between the cold-junction metal electrode 63p and the cold-junction metal electrode 63n. At this time, when the cold-junction metal electrode 63n is maintained at the reference potential, an infrared detection signal in accordance with the electromotive voltage is output from the cold-junction metal electrode 63p. Regarding the temperature relationship between the "hot junction" and "cold junction" of the thermoelectric converter 60, the temperature of the hot junction is not necessarily higher than the temperature of the cold junction. For example, when the infrared sensor 1 is used to detect the temperature of an object having a lower temperature than the infrared sensor 1, the temperature of the hot junction may be lower than the temperature of the cold junction. In this case, the polarity of the electromotive voltage of the thermoelectric converter 60 is reversed.

The source 80s of the transistor 80 is electrically connected to the metal wiring 83, which is positioned above the insulating film 32, via a metal via 81 extending in the insulating film 32 in the thickness direction of the insulating film 32. The metal wiring 83 is electrically connected to the cold-junction metal electrode 63p via the metal wiring 71. The drain 80d of the transistor 80 is electrically connected to the metal wiring 84, which is positioned above the insulating film 32, via a metal via 82 extending in the insulating film 32 in the thickness direction of the insulating film 32. The transistor 80, the metal vias 81 and 82, and the metal wiring 83 and 84 are each a part of the switch circuit 11.

Each of the hot-junction metal electrodes 61 and 62, the cold-junction metal electrodes 63p, 63n, 64p, and 64n, the metal wiring 67, the metal wiring 71, the metal wiring 83, and the metal wiring 84 is made of, for example, a meal such as aluminum. The metal vias 81 and 82 are made of, for example, a high-melting-point metal such as tungsten.

The floating supporter 50 may have a phononic crystal structure. For example, a phononic crystal structure is formed in the N-type semiconductors 65n and 66n and the P-type semiconductors 65p and 66p that pass through the floating supporter 50. When the floating supporter 50 has a phononic crystal structure, the temperature difference between the hot junction and the cold junction is maintained due to high heat insulating properties of the phononic crystal structure, and thus the sensitivity of the infrared sensor 1 can be increased.

An artificial phononic crystal structure formed by a semiconductor manufacturing process is a structure in which microscopic pores each having a diameter of several tens of nanometer level are formed and periodically arranged. The period of the pores is, for example, greater than or equal to 1 nm and less than or equal to 300 nm. The diameter of each of the pores is, for example, greater than or equal to 10 nm and less than or equal to 50 nm.

Because the wavelength of phonon that carries heat is mainly in the range of 1 nm to 300 nm, when the period is in such a range, the phononic crystal structure can easily have high heat insulating properties. Electron-beam lithography is suitable for forming a phononic crystal structure having a period greater than or equal to about 100 nm and less than or equal to about 300 nm. Block copolymer (BCP) lithography is suitable for forming a phononic crystal structure having a period greater than or equal to about 1 nm and less than or equal to about 100 nm. By using lithography and dry etching, it is possible to form microscopic through-holes in the semiconductor 42 (including a doped region), which is made of polycrystalline silicon or the like and included in the floating supporter 50. In doing so, if the aspect ratio (depth/diameter) of each of holes is greater than or equal to 5, an etching gas can easily enter the holes and the holes can be easily formed. For example, an etching gas can etch holes each having a diameter of 20 nm to extend through a polycrystalline silicon thin film having a thickness of 100 nm and form a phononic crystal structure having a hole diameter 20 nm. Because it is difficult to balance between the shape of holes and the productivity when holes each having an aspect ratio higher than 5 are to be formed, it is preferable that the film thickness of the floating supporter 50 having a phononic crystal structure be less than or equal to about 100 nm.

### [Method of Manufacturing Infrared Sensor]

Next, a method of manufacturing the infrared sensor 1 will be described. The manufacturing method described below is an example, and a method of manufacturing the infrared sensor 1 is not limited to the following example.

Figs. 4A to 4C are sectional views illustrating the method of manufacturing the infrared sensor 1 according to the first embodiment.

First, as illustrated in Fig. 4A, the insulating film 32 is formed by CVD (Chemical Vapor Deposition) on the semiconductor substrate 31 in which the transistor 80 has been formed. The insulating film 32 is, for example, a silicon oxide film. A circuit element other than the transistor 80, such as a MOSFET, to be included in the infrared sensor 1 may have been formed in the semiconductor substrate 31. Next, a recessed space 53 is formed by dry etching a portion to be positioned below the light receiver 40 and the floating supporter 50 (a portion where the gap 51 is to be formed later). Moreover, a thin protective film 33 is deposited by CVD on the insulating film 32 in which the recessed space 53 is formed. The protective film 33 is, for example, a silicon oxide film.

Next, as illustrated in Fig. 4B, the material of a sacrificial layer 55 is deposited so as to fill the recessed space 53, and the upper surfaces of the insulating film 32 and the sacrificial layer 55 are exposed by CMP (Chemical Mechanical Polishing). The material of the sacrificial layer 55 is, for example, polycrystalline silicon.

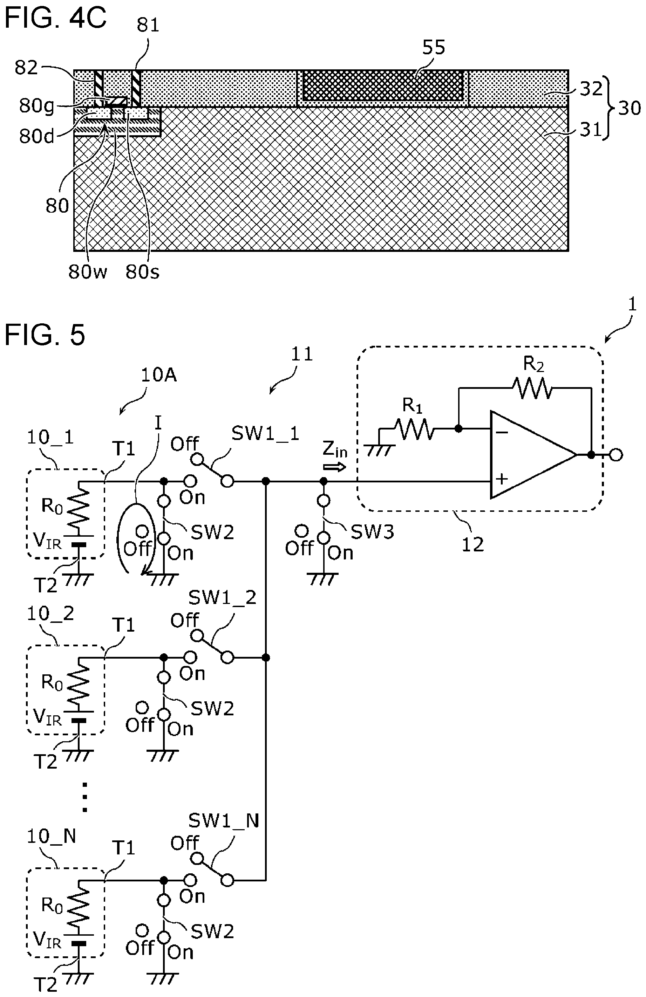

Next, as illustrated in Fig. 4C, in order to wire the transistor 80, the metal vias 81 and 82 are formed by forming via holes by dry etching the insulating film 32, filling the via holes with tungsten, and performing CMP again. In forming of the metal vias 81 and 82, a film of titanium nitride or the like may be formed as an underlying close-contact layer before depositing tungsten into the via holes.

Subsequently, the light receiver 40, the floating supporter 50, the thermoelectric converter 60, and various metal wiring are formed, and then the gap 51 is formed by etching the sacrificial layer 55 by using xenon fluoride (XeF₂) to obtain a structure illustrated in Figs. 3A and 3B. Such a manufacturing process is performed in other portions of the semiconductor substrate 31 to form the infrared sensor 1 including multiple infrared sensor elements 10. For example, a process used for semiconductor device manufacturing is used to form the light receiver 40, the floating supporter 50, the thermoelectric converter 60, and various metal wiring.

### [Circuit Configuration and Operation]

Next, details of the circuit configuration and the operation of the infrared sensor 1 according to the present embodiment will be described while referring also to infrared sensors according to comparative examples.

Fig. 5 illustrates the circuit configuration of the infrared sensor 1 according to the first embodiment. In Fig. 5, the circuit configuration of the element array 10A, the switch circuit 11, and the amplifier 12 is illustrated, and illustration of the other circuit configurations of the infrared sensor 1 is omitted. In Fig. 5, for discrimination, the infrared sensor elements 10 are denoted as infrared sensor elements 10_1 to 10_N. In Fig. 5, as with Figs. 1A to 1E, each of the infrared sensor elements 10_1 to 10_N is equivalently represented as a serial connection of a voltage source that generates the electromotive voltage V_{IR} and the internal resistance R₀. The same applies to the following figures illustrating circuit configurations. In Fig. 5, the state of switches in the noise measurement mode is illustrated.

As illustrated in Fig. 5, the infrared sensor 1 includes, as switches included in the switch circuit 11, serial switches SW1_1 to SW1_N, parallel switches SW2_1 to SW2_N, and a parallel switch SW3. The serial switches SW1_1 to SW1_N are examples of second switches. The parallel switches SW2_1 to SW2_N are examples of first switches. The parallel switch SW3 is an example of a third switch.

Each of the serial switches SW1_1 to SW1_N corresponds to the serial switch SW1 described above in "(Underlying Knowledge Forming Basis of the Present Disclosure)". Hereafter, each of the serial switches SW1_1 to SW1_N may be simply referred to as a "serial switch SW1". Each of the parallel switches SW2_1 to SW2_N corresponds to the parallel switch SW2 described above in "(Underlying Knowledge Forming Basis of the Present Disclosure)". Hereafter, each of the parallel switches SW2_1 to SW2_N may be simply referred to as a "parallel switch SW2". The contents described above in "(Underlying Knowledge Forming Basis of the Present Disclosure)" can be applied to the parallel switch SW3. The contents described above in "(Underlying Knowledge Forming Basis of the Present Disclosure)" can also be applied to the infrared sensor elements 10_1 to 10_N and the amplifier 12. Therefore, matters that have already been described will be omitted or simplified.

The infrared sensor 1 has a configuration such that one infrared sensor element 10 of the infrared sensor according to the configuration example 5 described above is expanded to the infrared sensor elements 10_1 to 10_N (in other words, pixels).

In the infrared sensor 1, N infrared sensor elements 10_1 to 10_N are connected in parallel to one amplifier 12 via the switch circuit 11. That is, the infrared sensor elements 10_1 to 10_N and the amplifier 12 have a many-to-one relationship.

The serial switches SW1_1 to SW1_N are connected on-to-one to the infrared sensor elements 10_1 to 10_N. The serial switches SW1_1 to SW1_N are connected to the amplifier 12 so that each of the serial switches SW1_1 to SW1_N can independently block transmission of an infrared detection signal from a corresponding one of the infrared sensor elements 10_1 to 10_N to the amplifier 12. Each of the serial switches SW1_1 to SW1_N individually switches between electrical connection and electrical disconnection between a corresponding one of the infrared sensor elements 10_1 to 10_N and the amplifier 12. The other ends of the serial switches SW1_1 to SW1_N are connected to each other. One end of the one parallel switch SW3 is connected between the other ends of the serial switches SW1_1 to SW1_N and the amplifier 12.

The parallel switches SW2_1 to SW2_N are connected on-to-one to the infrared sensor elements 10_1 to 10_N. One end of each of the parallel switches SW2_1 to SW2_N is connected between a corresponding one of the sets of the infrared sensor elements 10_1 to 10_N and the serial switches SW1_1 to SW1_N that are connected one-to-one. Each of the parallel switches SW2_1 to SW2_N connects the first terminal T1, which outputs an infrared detection signal, and the second terminal T2, which is maintained at a predetermined potential, of the infrared sensor element 10, so that each of the parallel switches SW2_1 to SW2_N is capable of short-circuiting the first terminal T1 and the second terminal T2.

The first terminal T1 and the second terminal T2 are included in the thermoelectric converter 60 described above. The first terminal T1 is, for example, the cold-junction metal electrode 63p of the thermoelectric converter 60 or a part of wiring extending from the cold-junction metal electrode 63p toward the amplifier 12. The second terminal T2 is, for example, the cold-junction metal electrode 63n of the thermoelectric converter 60 or a part of wiring for connecting the cold-junction metal electrode 63n to the reference potential.

The parallel switch SW3 is connected to the input terminal of the amplifier 12, and is capable of short-circuiting the input terminal to the reference potential.

The tail ends of the reference numerals of the infrared sensor elements 10_1 to 10_N, the serial switches SW1_1 to SW1_N, and the parallel switches SW2_1 to SW2_N represent correspondence between these. The elements and switches having reference numerals with the same tail end are connected to each other.

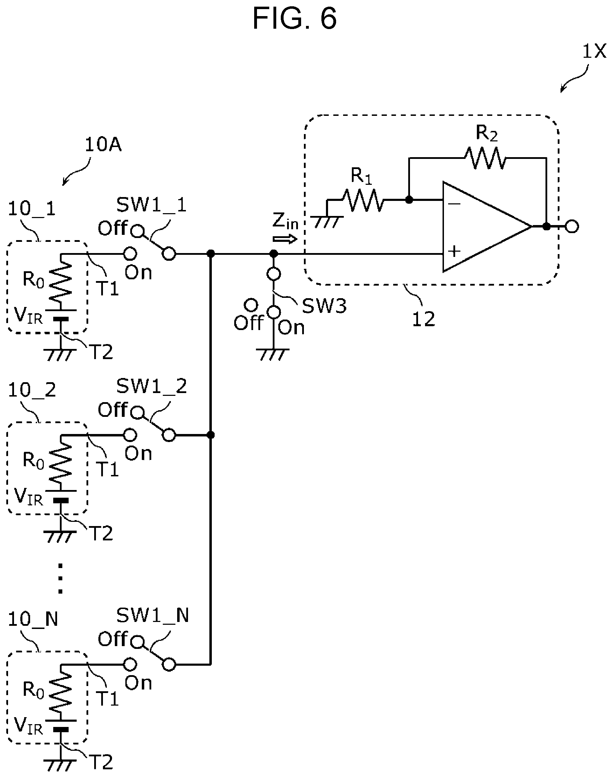

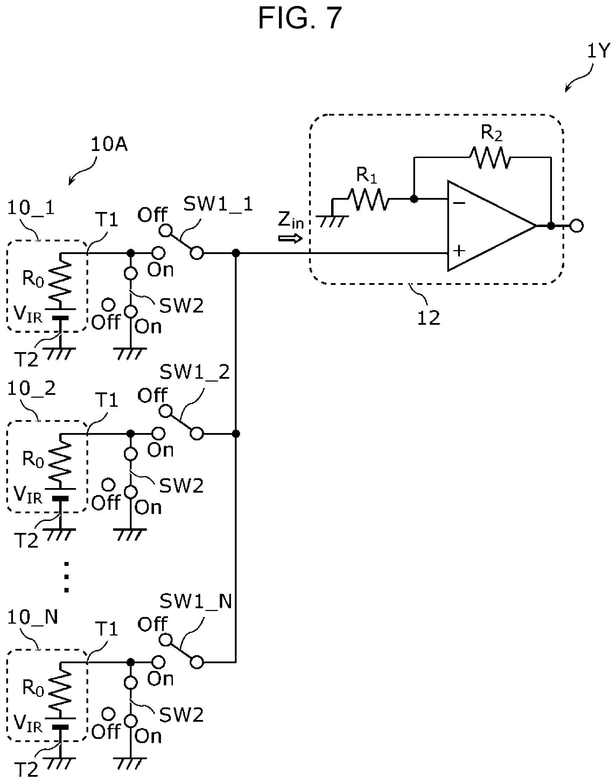

Next, infrared sensor elements according to comparative examples will be described. Fig. 6 illustrates the circuit configuration of an infrared sensor 1X according to a comparative example 1. Fig. 7 illustrates the circuit configuration of an infrared sensor 1Y according to a comparative example 2. In Figs. 6 and 7, the state of switches in the noise measurement mode is illustrated.

As illustrated in Fig. 6, the infrared sensor 1X according to the comparative example 1 has a configuration such that the parallel switches SW2_1 to SW2_N are removed from the infrared sensor 1 according to the first embodiment. The infrared sensor 1X has a configuration such that one infrared sensor element 10 of the infrared sensor according to the configuration example 3 is expanded to multiple infrared sensor elements 10_1 to 10_N (in other words, multiple pixels).

As illustrated in Fig. 7, the infrared sensor 1Y according to the comparative example 2 has a configuration such that the parallel switch SW3 is removed from the infrared sensor 1 according to the first embodiment. The infrared sensor 1Y has a configuration such that one infrared sensor element 10 according to the configuration example 2 or the configuration example 4 is expanded to multiple infrared sensor elements 10_1 to 10_N (multiple pixels).

With the infrared sensor according to the comparative example 1 and the comparative example 2, an error may be generated in the output of the amplifier 12 because a single infrared sensor element 10 (pixel) is changed to multiple infrared sensor elements 10_1 to 10_N (multiple pixels). In contrast, with the infrared sensor 1 according to the first embodiment, an error in the output of the amplifier 12 is suppressed. Details of this fact will be described below together with the operation of each switch of the switch circuit 11. The operation of each switch of the switch circuit 11 described below is performed based on control by the control circuit 13.

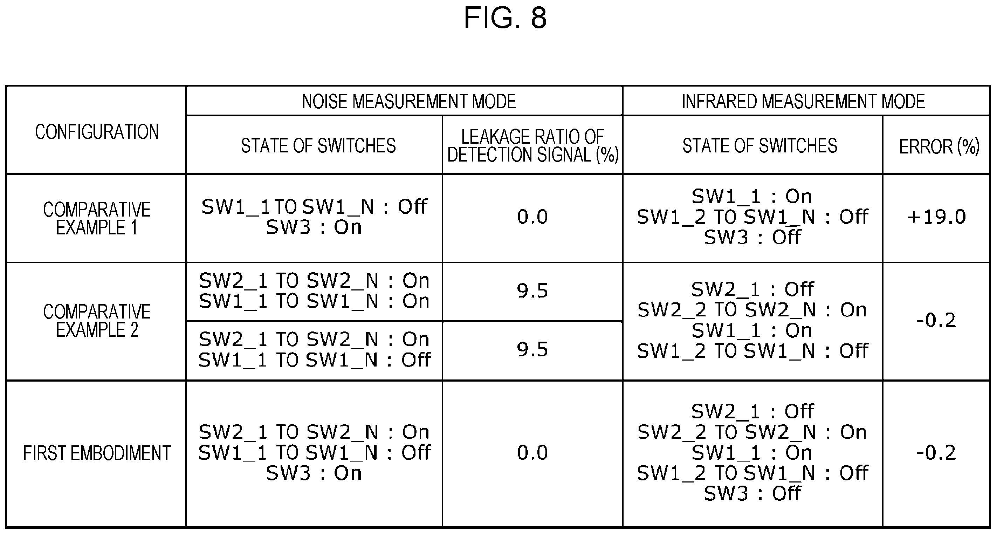

Fig. 8 is a table showing the result of calculating the leakage of the infrared detection signal in the infrared sensors according to the first embodiment, the comparative example 1, and the comparative example 2. Fig. 8 shows, in the rows "Comparative Example 1" to "First Embodiment" of the table, the state of the switches and the leakage ratio of the infrared detection signal in the noise measurement mode, and the state of the switches and the error of the infrared detection signal in the infrared measurement mode of the infrared sensors according to the first embodiment, the comparative example 1, and the comparative example 2. The definitions of the leakage ratio of the infrared detection signal and the error of the infrared detection signal are the same as those described with reference to Fig. 1F.

In Fig. 8, the leakage ratio of the infrared detection signal and the error of the infrared detection signal are calculated under the following conditions. The resistance of each of the serial switches SW1_1 to SW1_N, the parallel switches SW2_1 to SW2_N, and the parallel switch SW3 is 1 GΩ when they are off and is 100 Ω when they are on. The number of the infrared sensor elements 10_1 to 10_N is 20. The input impedance Zᵢₙ of the amplifier 12 is 100 GΩ. It is also assumed that, in the infrared measurement mode, among the infrared sensor elements 10_1 to 10_N, only the infrared sensor element 10_1 is selected and outputs an infrared detection signal. That is, in the following description, the selected pixel is the infrared sensor element 10_1, and the unselected pixels are the infrared sensor elements 10_2 to 10_N. Moreover, it is assumed that the infrared sensor elements 10_2 to 10_N are irradiated with strong infrared light that generates an electromotive voltage V_{RI} that is as high as 100 times the electromotive voltage V_{RI} of the infrared sensor element 10_1.

First, the operation of the infrared sensor 1X according to the comparative example 1 and the result of calculating the leakage of the infrared detection signal will be described.

As shown in Fig. 8, in the noise measurement mode, the infrared sensor 1X according to the comparative example 1 turns off each of the serial switches SW1_1 to SW1_N, and turns on the parallel switch SW3. In the infrared measurement mode, among the serial switches SW1_1 to SW1_N, the infrared sensor 1X turns on only the serial switch SW1_1 connected to the selected pixel, and turns off the serial switches SW1_2 to SW1_N connected to the unselected pixels. In the infrared measurement mode, the infrared sensor 1X turns off the parallel switch SW3.

As a result of such an operation, as shown in the row "COMPARATIVE EXAMPLE 1" of Fig. 8, the leakage ratio of the infrared detection signal in the noise measurement mode is 0.0%. On the other hand, the error of the infrared detection signal in the infrared measurement mode is as large as +19.0%, and a large error is generated. This is because, when infrared detection signals generated from the unselected pixels are strong, the infrared detection signals leak to the amplifier 12 since the resistance of each of the serial switches SW1_2 to SW1_N connected to the unselected pixels is not infinity when the serial switches SW1_2 to SW1_N are off, and thus an infrared detection signal of the selected pixel becomes stronger than it is in reality.

Next, the operation of the infrared sensor 1Y according to the comparative example 2 and the result of calculating the leakage of the infrared detection signal will be described.

As shown in Fig. 8, in the noise measurement mode, the infrared sensor 1Y according to the comparative example 2 turns on each of the parallel switches SW2_1 to SW2_N, and turns on each of the serial switches SW1_1 to SW1_N. In the noise measurement mode, the infrared sensor 1Y may turn On each of the parallel switches SW2_1 to SW2_N, and may turn off each of the serial switches SW1_1 to SW1_N. In the infrared measurement mode, among the parallel switches SW2_1 to SW2_N, the infrared sensor 1Y turns off only the parallel switch SW2_1 connected to the selected pixel, and turns on the parallel switches SW2_2 to SW2_N connected to the unselected pixels. In the infrared measurement mode, among the serial switch SW1_1-SW1_N, the infrared sensor 1Y turns on only the serial switch SW1_1 connected to the selected pixel, and turns off the serial switches SW1_2 to SW1_N connected to the unselected pixels.

As a result of such an operation, as shown in the row "COMPARATIVE EXAMPLE 2" of Fig. 8, the leakage ratio of the infrared detection signal in the noise measurement mode is as high as 9.5% in both of the cases where each of the serial switches SW1_1 to SW1_N is turned on and off. The error of the infrared detection signal in the infrared measurement mode is -0.2%. The reason why the leakage ratio of the infrared detection signal is high is that infrared detection signals that have leaked from the infrared sensor elements 10_1 to 10_N are superposed on each other and become easier to be transmitted to the amplifier 12. To be specific, with the infrared sensors according to the configuration example 2 and the configuration example 4 described above, an infrared detection signal does not easily leak from the infrared sensor element 10 and the leakage ratio of the infrared detection signal is low because the parallel switch SW2 is on. In contrast, with the infrared sensor 1Y, infrared detection signals that have leaked are superposed on each other, because multiple infrared sensor elements 10_1 to 10_N exist. As a result, in the infrared sensor 1Y, the leakage ratio of the infrared detection signal is high.

Next, the operation of the infrared sensor 1 according to the first embodiment and the result of calculating the leakage of the infrared detection signal will be described.

As shown in Fig. 8, in the noise measurement mode, the infrared sensor 1 according to the first embodiment turns on the parallel switches SW2_1 to SW2_N, turns off the serial switches SW1_1 to SW1_N, and turns on the parallel switch SW3. In the infrared measurement mode, among the parallel switches SW2_1 to SW2_N, the infrared sensor 1 turns off only the parallel switch SW2_1 connected to the selected pixel, and turns on the parallel switches SW2_2 to SW2_N connected to the unselected pixels. In the infrared measurement mode, among the serial switches SW1_1 to SW1_N, the infrared sensor 1 turns on only the serial switch SW1_1 connected to the selected pixel, and turns off the serial switches SW1_2 to SW1_N connected to the unselected pixels. In the infrared measurement mode, the infrared sensor 1 turns off the parallel switch SW3.

As a result of such an operation, as shown in the row "FIRST EMBODIMENT" of Fig. 8, the leakage ratio of the infrared detection signal in the noise measurement mode is 0.0%. The error of the infrared detection signal in the infrared measurement mode is - 0.2%. Therefore, it is possible to cancel the offset component and the 1/f noise of the amplifier 12 by calculating the difference in the output of the amplifier 12 between the infrared measurement mode and the noise measurement mode. This cancel processing is performed, for example, by the signal processing circuit 100.

In this way, because the infrared sensor 1 includes the parallel switches SW2_1 to SW2_N, the infrared sensor 1 is improved compared with the infrared sensor 1X in terms of the error of the infrared detection signal. The reason for this is as follows. In the infrared detection mode, because the parallel switches SW2_1 to SW2_N are on, the first terminals T1, from which infrared detection signals are output, and the second terminals T2 are short-circuited in the infrared sensor elements 10_2 to 10_N. As a result, infrared detection signals generated by the infrared sensor elements 10_2 to 10_N, which are unselected pixels, do not easily leak to the amplifier 12. Thus, the error of the infrared detection signal in the infrared detection mode is improved.

Moreover, because the infrared sensor 1 includes the parallel switch SW3, the infrared sensor 1 is improved compared with the infrared sensor 1Y in terms of the leakage ratio of the infrared detection signal. The reason for this is as follows. In the noise measurement mode, because the parallel switches SW2_1 to SW2_N are on, the first terminals T1, from which infrared detection signals are output, and the second terminals T2 are short-circuited in the infrared sensor elements 10_1 to 10_N. As a result, infrared detection signals generated by the infrared sensor elements 10_1 to 10_N do not easily leak to the amplifier 12. Moreover, with the infrared sensor 1, in the noise measurement mode, because the parallel switch SW3 is on, the input terminal of the amplifier 12 is short-circuited to the reference potential, and infrared detection signals leaked from the infrared sensor elements 10_1 to 10_N do not easily affect the input to the amplifier 12. Thus, the leakage ratio of the infrared detection signal in the noise measurement mode is improved.

As described above with reference to Fig. 8, with the circuit configuration of each of the infrared sensors according to the configuration examples 2 to 4, in which the number of infrared sensor element 10 is one, the leakage ratio and the error of the infrared detection signal are improved. However, when the circuit configuration is expanded to a circuit configuration including multiple infrared sensor elements 10 as in the comparative example 1 and the comparative example 2, an error is easily generated in the output of the amplifier 12. To be specific, with the infrared sensor 1X according to the comparative example 1, an error of the infrared detection signal is generated in the infrared measurement mode, and, with the infrared sensor 1Y according to the comparative example 2, leakage of the infrared detection signal occurs in the noise measurement mode. In contrast, with the infrared sensor 1 according to the first embodiment, it is possible to suppress both of the leakage of the infrared detection signal in the noise measurement mode and the error of the infrared detection signal in the infrared measurement mode. Thus, the infrared sensor 1 according to the first embodiment can increase the infrared detection accuracy.

### (Second Embodiment)

Next, an infrared sensor according to a second embodiment will be described. In the following description, differences from the first embodiment will be mainly described, and descriptions of features in common will be omitted or simplified.

### [Overall Configuration]

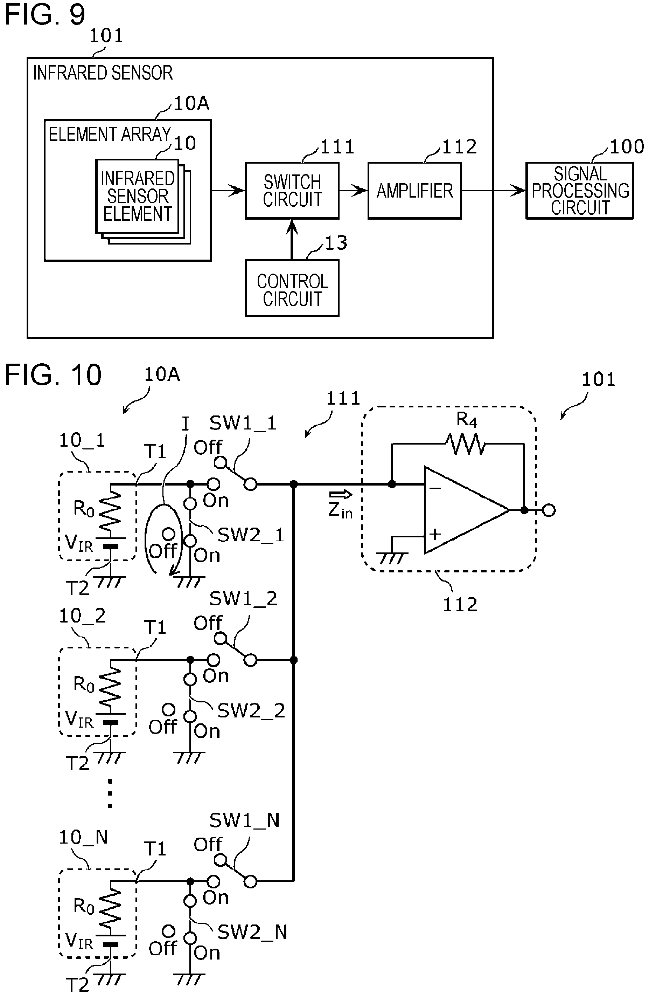

Fig. 9 is a block diagram illustrating the overall configuration of an infrared sensor 101 according to the second embodiment.

As illustrated in Fig. 9, the infrared sensor 101 according to the present embodiment differs from the infrared sensor 1 according to the first embodiment in that the infrared sensor 101 includes a switch circuit 111 and an amplifier 112 instead of the switch circuit 11 and the amplifier 12.

The switch circuit 111 is a circuit that includes switches and wiring and connects the element array 10A and the amplifier 112. Detailed configuration of the switch circuit 111 will be described below.

The amplifier 112 amplifies infrared detection signals generated by the infrared sensor elements 10. The amplifier 112 is a current-input amplifier having a low input impedance. The amplifier 12 is, for example, a transimpedance amplifier (current-input voltage-output amplifier). However, as long as the amplifier 12 is an active element having a low input impedance, the amplifier 12 is not limited to a transimpedance amplifier, and may be a current amplifier (current-input current-output amplifier).

### [Circuit configuration and Operation]

Next, the circuit configuration of the infrared sensor 101 according to the present embodiment will be described.

Fig. 10 illustrates the circuit configuration of the infrared sensor 101 according to the second embodiment. In Fig. 10, the circuit configuration of the infrared sensor element 10, the switch circuit 111, and the amplifier 112 is illustrated, and illustration of the other circuit configurations of the infrared sensor 101 is omitted. In Fig. 10, the state of switches in the noise measurement mode is illustrated.

As illustrated in Fig. 10, the infrared sensor 101 has a configuration such that the amplifier 12 of the infrared sensor 1Y according to the comparative example 2 is changed to the amplifier 112. The infrared sensor 101 includes, as switches included in the switch circuit 111, the serial switches SW1_1 to SW1_N and the parallel switches SW2_1 to SW2_N. The serial switches SW1_1 to SW1_N are examples of second switches. The parallel switches SW2_1 to SW2_N are examples of first switches. The switch circuit 111 has a configuration such that the parallel switch SW3 is removed from the switch circuit 11 described above.

In the infrared sensor 101, N infrared sensor elements 10_1 to 10_N are connected in parallel to one amplifier 112 via the switch circuit 111. That is, the infrared sensor elements 10_1 to 10_N and the amplifier 112 have a many-to-one relationship.

In the example illustrated in Fig. 10, the amplifier 112 is a transimpedance amplifier. The transimpedance amplifier includes, for example, an operation amplifier and a resistor. The transimpedance amplifier is, for example, an inverting amplifier using an operation amplifier. The transimpedance amplifier has an input impedance Zᵢₙ that is extremely low and can be regarded as zero. The output voltage of the transimpedance amplifier having a feedback resistance R₄ illustrated Fig. 10 is -R₄ times a current that flows into the input terminal of the transimpedance amplifier.

Next, the operation of the infrared sensor 101 according to the second embodiment and the result of calculating the leakage of the infrared detection signal will be described. The operation of each switch of the switch circuit 111 described below is performed based on control by the control circuit 13.

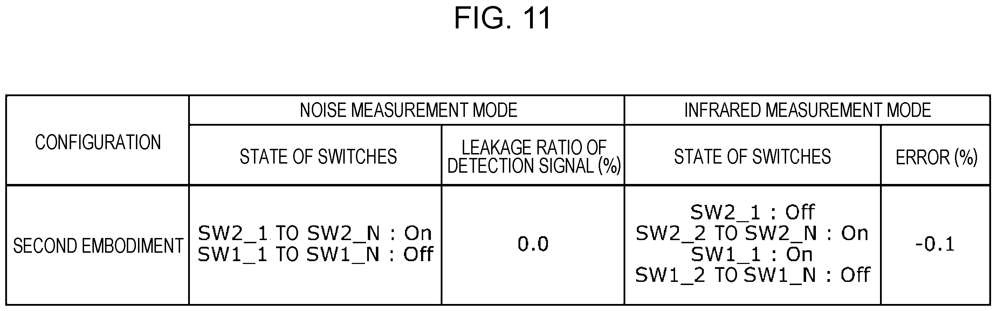

Fig. 11 is a table showing the result of calculating the leakage of the infrared detection signal in the infrared sensor 101 according to the second embodiment. Fig. 11 shows, in the row "SECOND EMBODIMENT" of the table, the state of the switches and the leakage ratio of the infrared detection signal in the noise measurement mode and the state of the switches and the error of the infrared detection signal in the infrared measurement mode of the infrared sensor 101 according to the second embodiment.

The definitions of the leakage ratio of the infrared detection signal (the column "LEAKAGE RATIO OF DETECTION SIGNAL (%)" in the table) and the error of the infrared detection signal (the column "ERROR (%)" in the table) in Fig. 11 are as follows. The leakage ratio of the infrared detection signal in the noise measurement mode is the ratio (%) of the current that flows into the input of the amplifier 12 to an electromotive current V_{IR}/R₀ generated by the infrared sensor element 10 in the noise measurement mode. The error of the infrared detection signal in the infrared measurement mode is the error (%) of the current that flows into the input of the amplifier 12 with respect to the electromotive current V_{IR}/R₀ generated by the infrared sensor element 10, that is, the ratio (%) of the difference between the electromotive current V_{IR}/R₀ generated by the infrared sensor element 10 and the current that flows into the input of the amplifier 12 to the electromotive current V_{IR}/R₀ generated by the infrared sensor element 10 in the infrared measurement mode.

In Fig. 11, the leakage ratio of the infrared detection signal and the error of the infrared detection signal are calculated under the following conditions. The resistance of each of the serial switches SW1_1 to SW1_N and the parallel switches SW2_1 to SW2_N is 1 GΩ when they are off and is 100 Ω when they are on. The number of infrared sensor elements 10_1 to 10_N is 20. The input impedance Zᵢₙ of the amplifier 112 is 0 Ω. It is also assumed that, in the infrared measurement mode, among the infrared sensor elements 10_1 to 10_N, only the infrared sensor element 10_1 is selected and outputs an infrared detection signal. That is, in the following description, the selected pixel is the infrared sensor element 10_1, and the unselected pixels are the infrared sensor elements 10_2 to 10_N. Moreover, it is assumed that the infrared sensor elements 10_2 to 10_N are irradiated with strong infrared light that generates an electromotive voltage V_{RI} that is as high as 100 times the electromotive voltage V_{RI} of the infrared sensor element 10_1.

As shown in Fig. 11, in the noise measurement mode, the infrared sensor 101 according to the second embodiment turns on each of the parallel switches SW2_1 to SW2_N, and turns off each of the serial switches SW1_1 to SW1_N. In the infrared measurement mode, among the parallel switches SW2_1 to SW2_N, the infrared sensor 101 turns off only the parallel switch SW2_1 connected to the selected pixel, and turns on parallel switches SW2_2 to SW2_N connected to the unselected pixels. In the infrared measurement mode, among the serial switches SW1_1 to SW1_N, the infrared sensor 101 turns on only the serial switch SW1_1 connected to the selected pixel, and turns off the serial switches SW1_2 to SW1_N connected to the unselected pixels.

As a result of such an operation, as shown in the row "SECOND EMBODIMENT" of Fig. 11, the leakage ratio of the infrared detection signal in the noise measurement mode is 0.0%. The error of the infrared detection signal in the infrared measurement mode is -0.1%. Therefore, it is possible to cancel the offset component and the 1/f noise of the amplifier 112 by calculating the difference in the output of the amplifier 112 between the infrared measurement mode and the noise measurement mode. This cancel processing is performed, for example, by the signal processing circuit 100.

In this way, because the infrared sensor 101 includes the amplifier 112, the leakage ratio of the infrared detection signal in the noise measurement mode is improved compared with the infrared sensor 1Y according to the comparative example 2. This is because, since the input impedance of the amplifier 112 is low, even when an infrared detection signal leaks from the infrared sensor element 10, the leaked signal does not easily emerge as a voltage that is the product of the leaked current and the input impedance.

As described above with reference to Fig. 11, the infrared sensor 101 includes the switch circuit 111 similar to that of the infrared sensor 1Y according to the comparative example 2, which has a problem of the leakage of the infrared detection signal in the noise measurement mode. However, it has been shown that, with the infrared sensor 101, the problem can be solved, because the voltage-input amplifier is changed to the current-input amplifier. Thus, the infrared sensor 101 according to the second embodiment can increase the infrared detection accuracy.

Moreover, the number of switches can be reduced, because the number of switches in the switch circuit 111 of the infrared sensor 101 according to the second embodiment is 2N, whereas the number of switches in the switch circuit 11 of the infrared sensor 1 according to the first embodiment is 2N + 1.

Furthermore, the infrared sensor 101 according to the second embodiment has an advantage that substantially the same current flows through the infrared sensor element 10 in the noise measurement mode and in the infrared measurement mode. For example, regarding the infrared sensor element 10_1, because the parallel switch SW2_1 is turned on and the serial switch SW1_1 is turned off in the noise measurement mode, the short-circuit current V_{IR}/R₀ (I in Fig. 10) flows through the infrared sensor element 10_1. Subsequently, when the infrared sensor element 10_1 is selected in the infrared measurement mode and the parallel switch SW2_1 is turned off and the serial switch SW1_1 is turned on, because the input impedance Zᵢₙ of the amplifier 112 can be regarded as zero, a current having the same magnitude as the short-circuit current V_{IR}/R₀ in the noise measurement mode flows into the amplifier 112. The short-circuit current is, for example, a current that flows through the P-type semiconductors 65p and 66p and the N-type semiconductors 65n and 66n of the thermoelectric converter 60 of the infrared sensor element 10. The short-circuit current has a value that is determined by the electromotive voltage V_{IR}, which is generated due to the Seebeck effect based on the temperature difference between the hot junction and the cold junction, and the total resistance value R₀ of the P-type semiconductors 65p and 66p and the N-type semiconductors 65n and 66n.

The flow of the short-circuit current functions to reduce the temperature difference between the hot junction and the cold junction due to the Peltier effect, which is opposite to the Seebeck effect. However, if the infrared irradiation amount is constant, the temperature difference settles down to a steady state in which increase of the temperature difference due to infrared light irradiation and reduction of the temperature difference due to the flow of the short-circuit current balance out each other. Thus, even when the measurement mode is switched from the noise measurement mode to the infrared measurement mode, as long as the magnitude of a current that flows through the infrared sensor element 10 is the same the short-circuit current V_{IR}/R₀, a phenomenon such that the temperature distribution between the hot junction and the cold junction is temporarily disturbed and redistributed due to the switching of the measurement mode does not occur. That is, even when the measurement mode is switched from the noise measurement mode to the infrared measurement mode, it is not necessary to wait for a time necessary for the temperature distribution to be redistributed and settle down to a steady state, and the infrared detection accuracy is maintained when infrared information based on a current that flows from the selected infrared sensor element 10 to the amplifier 112 is read.

On the other hand, in the infrared sensor 1 according to the first embodiment, when the measurement mode is switched to the infrared measurement mode by turning off the parallel switch SW2_1, turning on the serial switch SW1_1, and turning off the parallel switch SW3, the short-circuit current V_{IR}/R₀ (I in Fig. 5), which flows through the infrared sensor element 10_1 in the noise measurement mode, decreases because the input impedance of the amplifier 12 is extremely high, and redistribution of the temperature distribution between the hot junction and the cold junction of the infrared sensor element 10_1 occurs. An error may be generated if infrared information is read without waiting for a time necessary for the redistribution. However, the infrared sensor 1 has no problem when it is used, for example, for an application such that a sufficient time can be provided to switch the measurement mode from the noise measurement mode to the infrared measurement mode.

**In** reality, a current that flows through a semiconductor switch is not strictly a short-circuit current, because the resistance value of a semiconductor switch when the semiconductor switch is on is not ideally zero and is in the range of several ohms to several hundreds of ohms. However, the current can be substantially regarded as a short-circuit current, as long as the resistance value is sufficiently lower than the internal resistance R₀ of the infrared sensor. Likewise, in the present specification, the expression "short circuit" includes a case where two or more entities are connected via a semiconductor switch that is on and are substantially short-circuited.

The aforementioned effect that the temperature distribution between the hot junction and the cold junction does not easily change even when the measurement mode is switched from the noise measurement mode to the infrared measurement mode can be particularly effective when the floating supporter 50 of the infrared sensor element 10 has a phononic crystal structure. When the floating supporter 50 has a phononic crystal structure, the heat resistance of the floating supporter 50, in which the thermoelectric converter 60 is provided, increases due to high heat insulating properties of the phononic crystal structure. As a result, the thermal time constant of a thermal circuit that is composed of the floating supporter 50, in which the thermoelectric converter 60 is provided, and the light receiver 40 generally increases, and it takes a longer time for redistribution of the temperature distribution between the hot junction and the cold junction. However, with the infrared sensor 101 using the amplifier 112, because the temperature distribution does not easily change before and after the measurement mode is switched from the noise measurement mode to the infrared measurement mode, the increase of the thermal time constant due to the phononic crystal structure does not easily deteriorate S/N and high-speed imaging performance.

### [Another Example of Operation]

Next, another example of the operation of the infrared sensor 101 according to the second embodiment will be described. **In** the above description, the infrared sensor 101 selects one infrared sensor element 10 in the infrared measurement mode. However, the infrared sensor 101 may select multiple infrared sensor elements 10.

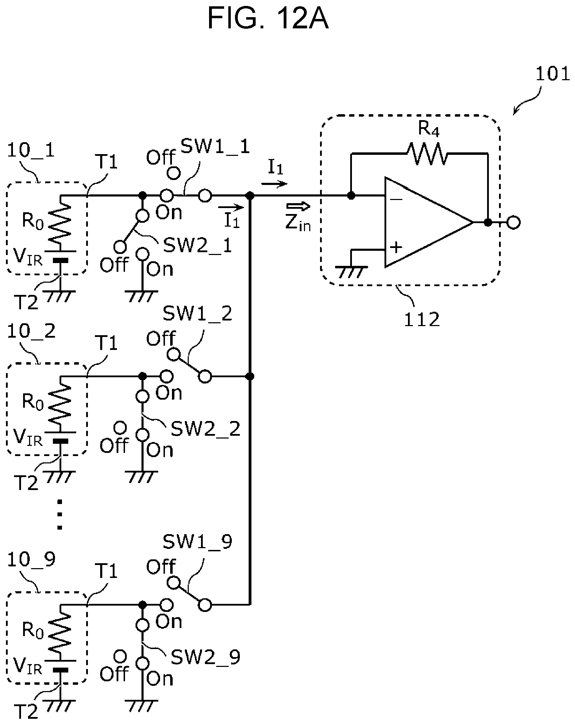

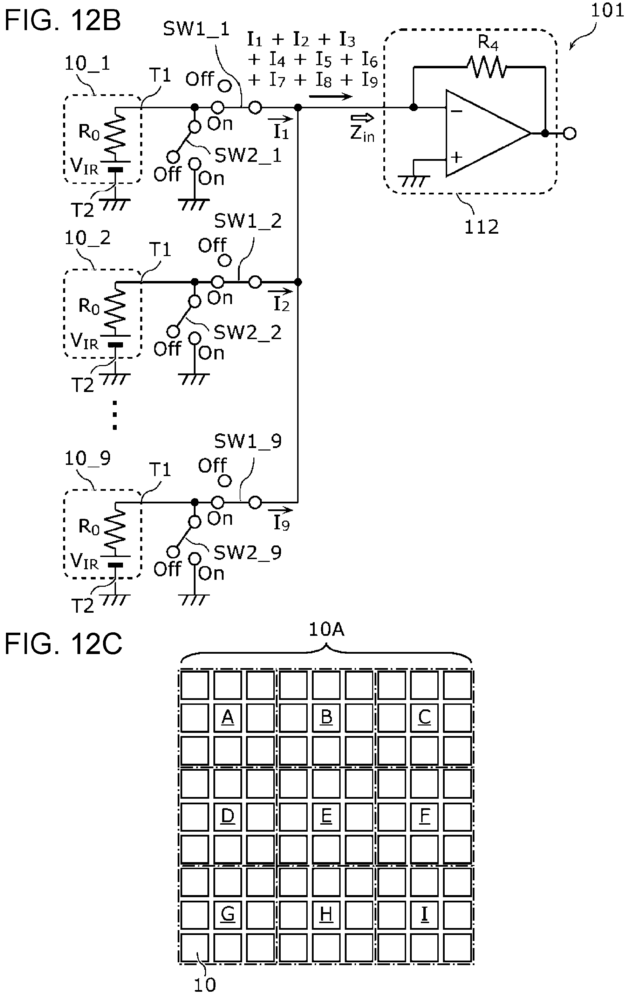

Fig. 12A illustrates an example of a switch operation in the infrared detection mode of the infrared sensor 101 according to the second embodiment. Fig. 12B illustrates another example of a switch operation in the infrared detection mode of the infrared sensor 101 according to the second embodiment. Fig. 12C is a plan view illustrating an example of the arrangement of the infrared sensor elements 10 in the element array 10A. Figs. 12A and 12B each illustrate the state of the switches of the switch circuit 111 in the infrared detection mode by using examples of nine infrared sensor elements 10_1 to 10_9 of the element array 10A and switches corresponding to the infrared sensor elements 10_1 to 10_9.

As illustrated in Fig. 12A, when only the infrared sensor element 10_1 is selected in the infrared measurement mode, the infrared sensor element 10_1 outputs a current I₁ corresponding to a short-circuit current, and the current I₁ flows into the amplifier 112. In the infrared measurement mode, such an operation is successively performed on the infrared sensor elements 10_2 to 10_9, thereby obtaining infrared information for nine pixels. Hereafter, such an operation of the switch circuit 111 may be referred to as an "individual output operation".

On the other hand, as illustrated in Fig. 12B, when all nine infrared sensor elements 10_1 to 10_9 are simultaneously selected in the infrared measurement mode, the infrared sensor elements 10_1 to 10_9 respectively output currents I₁ to I₉ each corresponding to a short-circuit current, and the total sum of the currents I₁ to I₉ flows into the amplifier 112. Thus, even if the infrared detection signal from each the infrared sensor elements 10_1 to 10_9 is very weak, detection can be performed by increasing the intensity of the infrared detection signal as the total sum for the nine pixels. Hereafter, such an operation of the switch circuit 111 may be referred to as a "block output operation".

Here, as illustrated in Fig. 12C, it is assumed that the element array 10A has a configuration such that, with one infrared sensor element 10 as one pixel, 9×9 = 81 pixels are divided into blocks each including 3×3 adjacent pixels. Fig. 12C illustrates blocks A to I that are partitioned by alternate long and short dash lines. When the individual output operation described above with reference to Fig. 12A is performed on each of the blocks A to I, in the infrared measurement mode, the infrared information of all 81 pixels is obtained by successively selecting only one of the nine pixels of each of the blocks A to I and repeatedly scanning the pixels. On the other hand, when the block output operation described above with reference to Fig. 12B is performed on each of the blocks A to I, the total sum of infrared information of the included nine pixels is obtained in each of the blocks A to I. In this case, although spatial resolution that can be represented by 81 pixels decreases to 1/9, even a very weak infrared detection signal is intensified in each of the blocks A to I and can be acquired as infrared information with improved S/N. One amplifier 112 may be provided in common for the blocks A to I, or may be provided for each of the blocks A to I.

In this way, with the block output operation, by simultaneously setting two or more of the parallel switches SW2 to an electrically connecting state, the control circuit 13 causes two or more infrared sensor elements 10 that are connected to the two or more parallel switches SW2 to simultaneously output infrared detection signals to the amplifier 112. Thus, the amplifier 112 amplifies a signal that is the sum of the infrared detection signals of the two or more infrared sensor elements 10 and outputs the amplified signal.

Whether to prioritize spatial resolution or to prioritize the S/N of infrared information, which is determined by the operation of the switches of the switch circuit 111, can be appropriately switched while monitoring the temperature distribution in a subject whose image is being captured. For example, the control circuit 13 acquires a command signal from an image capturer indicating by which of the individual output operation and the block output operation the switch circuit 111 is to be controlled, and controls the switch circuit 111 based on the acquired command signal.

The control circuit 13 may switch between the individual output operation and the block output operation based on an output of the amplifier 112 in the infrared detection mode by acquiring the output from the amplifier 112 in the infrared detection mode. For example, the control circuit 13 causes the switch circuit 111 to perform the individual output operation if the output from the amplifier 112 (for example, the average value or the maximum value of the output) is greater than or equal to a predetermined value, and causes the switch circuit 111 to perform the block output operation if the output from the amplifier 112 (for example, the average value or the maximum value of the output) is less than the predetermined value.

The reason why the block output operation can be performed as described above is that infrared detection signals from the infrared sensor elements 10 can be treated as currents and added by using the amplifier 112 having a low input impedance, such as a transimpedance amplifier.

### (Third Embodiment)

Next, an infrared sensor according to a third embodiment will be described. In the following description, differences from the first and second embodiments will be mainly described, and descriptions of features in common will be omitted or simplified.

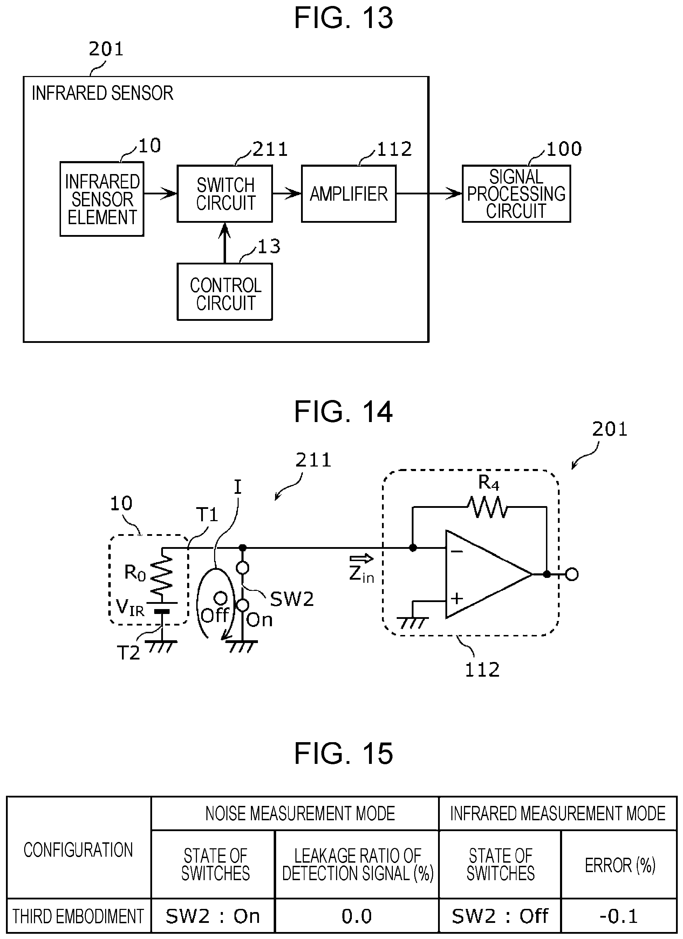

Fig. 13 is a bock diagram illustrating the overall configuration of an infrared sensor 201 according to the third embodiment.

As illustrated in Fig. 13, the infrared sensor 201 according to the present embodiment differs from the infrared sensor 101 according to the second embodiment in that the infrared sensor 201 includes one infrared sensor element 10 instead of the element array 10A composed of multiple infrared sensor elements 10 and includes a switch circuit 211 instead of the switch circuit 111.

The switch circuit 211 is a circuit that includes a switch and wiring and connects the infrared sensor element 10 and the amplifier 112. Detailed configuration of the switch circuit 211 will be described below.

Next, the circuit configuration of the infrared sensor 201 according to the present embodiment will be described.

Fig. 14 illustrates the circuit configuration of the infrared sensor 201 according to the third embodiment. In Fig. 14, the circuit configuration of the infrared sensor element 10, the switch circuit 211, and the amplifier 112 is illustrated, and illustration of the other circuit configurations of the infrared sensor 201 is omitted. In Fig. 14, the state of a switch in the noise measurement mode is illustrated.

The infrared sensor 201 has a configuration such that the infrared sensor elements 10 of the infrared sensor 101 according to the second embodiment are reduced to one infrared sensor element 10. The infrared sensor 201 also has a configuration such that the amplifier 12 of the infrared sensor according to the configuration example 4 is changed to the amplifier 112. In the infrared sensor 201, one infrared sensor element 10 is connected to one amplifier 112. That is, the infrared sensor element 10 and the amplifier 112 have a one-to-one relationship.

As illustrated in Fig. 14, the infrared sensor 201 includes one parallel switch SW2 as a switch included in the switch circuit 211. The parallel switch SW2 is an example of a first switch. The contents described above in "(Underlying Knowledge Forming Basis of the Present Disclosure)" can be applied to the parallel switch SW2.

Next, the operation of the infrared sensor 201 according to the third embodiment and the result of calculating the leakage of the infrared detection signal will be described. The operation of the parallel switch SW2 of the switch circuit 211 described below is performed based on control by the control circuit 13.

Fig. 15 is a table showing the result of calculating the leakage of the infrared detection signal in the infrared sensor 201 according to the third embodiment. Fig. 15 shows, in the row "THIRD EMBODIMENT" of the table, the state of the switches and the leakage ratio of the infrared detection signal in the noise measurement mode and the state of the switches and the error of the infrared detection signal in the infrared measurement mode of the infrared sensor 201 according to the third embodiment. Definitions of the leakage ratio of the infrared detection signal and the error of the infrared detection signal are the same as those described with reference to Fig. 11.

In Fig. 15, the leakage ratio of the infrared detection signal and the error of the infrared detection signal are calculated under the following conditions. The resistance of the parallel switch SW2 is 1 GΩ when it is off and is 100 Ω when it is on. The input impedance Zᵢₙ of the amplifier 112 is 0 Ω.

As shown in Fig. 15, the infrared sensor 201 according to the third embodiment turns on the parallel switch SW2 in the noise measurement mode. The infrared sensor 201 turns off the parallel switch SW2 in the infrared measurement mode.

As a result of such an operation, as shown in the row "THIRD EMBODIMENT" of Fig. 15, the leakage ratio of the infrared detection signal in the noise measurement mode is 0.0%. The error of the infrared detection signal in the infrared measurement mode is - 0.1%. Therefore, it is possible to cancel the offset component and the 1/f noise of the amplifier 112 by calculating the difference in the output of the amplifier 112 between the infrared measurement mode and the noise measurement mode. This cancel processing is performed, for example, by the signal processing circuit 100.

As described above with reference to Fig. 15, the infrared sensor 201 according to the third embodiment can increase the infrared detection accuracy, because an error is not easily generated in the output of the amplifier 112.

The infrared sensor 201 also includes the amplifier 112, which is a current-input amplifier having a low input impedance, as with the infrared sensor 101 according to the second embodiment. Therefore, even when the short-circuit current V_{IR}/R₀ (In in Fig. 14) due to the parallel switch SW2 is generated in the noise measurement mode, a current having the same magnitude as the short-circuit current V_{IR}/R₀ flows into the amplifier 112 also in the infrared measurement mode. Thus, also with the infrared sensor 201, as with the infrared sensor 101 described above, it is possible to obtain an advantageous effect that the temperature distribution between the hot junction and the cold junction does not easily change even when the measurement mode is switched from the noise measurement mode to the infrared measurement mode.

### (Other Embodiments)

Heretofore, an infrared sensor according to the present disclosure has been described based on embodiments. However, the present disclosure is not limited to these embodiments. Within the gist of the present disclosure, various modifications of the embodiments that a person having an ordinary skill in the art can conceive of and other embodiments constructed by combining some of the elements of the embodiments are also included in the scope of the present disclosure.

For example, the thermoelectric converter 60 is a thermopile-type thermoelectric conversion device in the embodiments described above. However, the thermoelectric converter 60 is not limited to this. The thermoelectric converter 60 may be a thermoelectric conversion device having a thermoelectric conversion structure other than a thermopile structure.

In the embodiments described above, the number of the amplifier 12 or 112 included in the infrared sensor 1, 101, or 201 is one. However, this is not a limitation. As long as the relationship between the number of the infrared sensor element(s) 10 and the number of the amplifier(s) 12 or 112 are consistent with each other, the infrared sensor 1, 101, or 201 may include multiple amplifiers 12 or 112. For example, in the infrared sensor 1 or 101, the amplifier 12 or 112 (AFE) may be provided for each of the pixel columns, pixel rows, or pixel blocks. For example, the infrared sensor 201 may be an infrared image sensor including multiple infrared sensor elements 10 and multiple amplifiers 112 in the same number as the infrared sensor elements 10.

### Industrial Applicability

An infrared sensor according to the present disclosure can be used for various applications including applications of existing infrared sensors such as an infrared imaging device. Because an infrared sensor according to the present disclosure is an uncooled high-accuracy infrared sensor, the infrared sensor is applicable to a driving monitor that can detect a person at night, a simple thermography that efficiently performs measurement of the body temperatures a group of people, and the like.

### Reference Signs List

1, 1X, 1Y, 101, 201 infrared sensor
10, 10_1 to 10_N infrared sensor element
10A element array
11, 111, 211 switch circuit
12, 112 amplifier
13 control circuit
30 substrate
31 semiconductor substrate
32, 41 insulating film
33 protective film
40 light receiver
42 semiconductor
50 floating supporter
51 gap
53 recessed space
55 sacrificial layer
60 thermoelectric converter
61, 62 hot-junction metal electrode
63n, 63p, 64n, 64p cold-junction metal electrode
65n, 66n N-type semiconductor
65p, 66p P-type semiconductor
67, 71, 83, 84 metal wiring
80 transistor
80d drain
80g gate
80s source
80w well
100 signal processing circuit
Lin infrared incident light
SW1, SW1_1 to SW1_N serial switch
SW2, SW2_1 to SW2_N, SW3 parallel switch

## Claims

1. An infrared sensor comprising:
a substrate;
a sensor element that generates an infrared detection signal;
a first switch that is connected to the sensor element; and
an amplifier that amplifies the infrared detection signal generated by the sensor element,
wherein the sensor element includes
a light receiver that is positioned above the substrate,
a floating supporter that joins the substrate and the light receiver and supports the light receiver in a floating manner so that a gap is formed between the substrate and the light receiver, and
a thermoelectric converter that generates the infrared detection signal based on heat generated by the light receiver,
wherein the thermoelectric converter includes a first terminal that outputs the infrared detection signal and a second terminal that is maintained at a predetermined potential,
wherein the first switch connects the first terminal and the second terminal so that the first switch is capable of short-circuiting the first terminal and the second terminal, and
wherein the amplifier is a current-input amplifier.

2. The infrared sensor according to claim 1, comprising:
sensor elements each of which is identical to the sensor element; and first switches each of which is identical to the first switch,
wherein the infrared sensor further comprises second switches that are connected one-to-one to the sensor elements, and
wherein each of the second switches is a semiconductor switch and individually switches between electrical connection and electrical disconnection between a corresponding one of the sensor elements and the amplifier.

3. The infrared sensor according to claim 2, further comprising:
a control circuit that causes, by simultaneously setting two or more of the second switches to an electrically connecting state, two or more of the sensor elements that are connected to the two or more second switches to simultaneously output the infrared detection signals to the amplifier.

4. The infrared sensor according to any one of claims 1 to 3,
wherein at least a part of the thermoelectric converter is provided in the floating supporter, and
wherein the floating supporter has a phononic crystal structure.

5. An infrared sensor comprising:
a substrate;
sensor elements each of which generates an infrared detection signal;
first switches that are connected one-to-one to the sensor elements;
an amplifier that amplifies the infrared detection signals generated by the sensor elements;
second switches that are connected one-to-one to the sensor elements and each of which individually switches between electrical connection and electrical disconnection between a corresponding one of the sensor elements and the amplifier; and
a third switch that is connected to an input terminal of the amplifier and that is capable of short-circuiting the input terminal to a reference potential,
wherein each of the sensor elements includes
a light receiver that is positioned above the substrate,
a floating supporter that joins the substrate and the light receiver and supports the light receiver in a floating manner so that a gap is formed between the substrate and the light receiver, and
a thermoelectric converter that generates the infrared detection signal based on heat generated by the light receiver,
wherein the thermoelectric converter includes a first terminal that outputs the infrared detection signal and a second terminal that is maintained at a predetermined potential,
wherein each of the first switches connects the first terminal and the second terminal so that the first switch is capable of short-circuiting the first terminal and the second terminal,
wherein each of the second switches is a semiconductor switch, and
wherein the amplifier is a voltage-input amplifier.

6. An infrared sensor comprising:
a substrate;
a sensor element that generates an infrared detection signal;
a first switch that is connected to the sensor element; and
an amplifier that amplifies the infrared detection signal generated by the sensor element,
wherein the sensor element includes
a light receiver that is positioned above the substrate,
a supporter that joins the substrate and the light receiver and supports the light receiver, and
a thermoelectric converter that generates the infrared detection signal based on heat generated by the light receiver,
wherein the thermoelectric converter includes a first terminal that outputs the infrared detection signal and a second terminal that is maintained at a predetermined potential,
wherein the first switch connects the first terminal and the second terminal so that the first switch is capable of short-circuiting the first terminal and the second terminal, and
wherein the amplifier is a current-input amplifier.
